# EUROPEAN PATENT APPLICATION

(11) **EP 4 391 042 A1**
(43) Date of publication of application: **26.06.2024**
(21) Application number: 23195683.0
(22) Date of filing: 06.09.2023
(51) Int. Cl.: H01L 23/00, G03F 7/20

(54) **EXPOSURE APPARATUS AND EXPOSURE METHOD**

(30) Priority: 21.12.2022 JP 2022204378
(71) Applicant: Kioxia Corporation, Tokyo 108-0023 (JP)
(72) Inventor: Mizuta, Yoshio, Tokyo, 108-0023 (JP)
(74) Representative: Marks & Clerk LLP

(57) **Abstract**

According to one embodiment, an exposure apparatus is configured to expose a substrate to light. The exposure apparatus includes a light source, a stage and a control device. The control device is configured to The control device is configured to calculate magnification components in a first direction and a second direction, based on measurement results of three or more alignment marks, the first direction and the second direction crossing each other and parallel with a surface of the substrate; and correct the exposure amount based on a value of a difference between the magnification component of the first direction and the magnification component of the second direction.

## Description

### CROSS-REFERENCE TO RELATED APPLICATION

This application is based upon and claims the benefit of priority from prior Japanese Patent Application No. 2022-204378, filed December 21, 2022.

### FIELD

Embodiments described herein relate generally to an exposure apparatus, and an exposure method.

### BACKGROUND

A three-dimensional stacking technique for three-dimensionally stacking semiconductor circuit substrates is known.

### BRIEF DESCRIPTION OF THE DRAWING(S)

FIG. 1 is a block diagram illustrating an example of a whole configuration of a memory device according to an embodiment.
FIG. 2 is a circuit diagram illustrating an example of a circuit configuration of a memory cell array included in the memory device according to the embodiment.
FIG. 3 is a perspective view illustrating an example of a structure of the memory device according to the embodiment.
FIG. 4 is a plan view illustrating an example of a planar layout of a memory cell array included in the memory device according to the embodiment.
FIG. 5 is a cross-sectional view illustrating an example of a cross-sectional structure of a memory pillar included in the memory device according to the embodiment.
FIG. 6 is a cross-sectional view taken along line VI-VI of FIG. 5 and illustrating an example of a cross-sectional structure of the memory pillar included in the memory device according to the embodiment.
FIG. 7 is a cross-sectional view illustrating an example of a cross-sectional structure of the memory device according to the embodiment.
FIG. 8 is a plan view illustrating an example of a planar layout of a film stress adjustment layer included in the memory device according to the embodiment.
FIG. 9 is a cross-sectional view taken along line IX-IX of FIG. 8 and illustrating an example of a cross-sectional structure of the film stress adjustment layer included in the memory device according to the embodiment.
FIG. 10 is a block diagram illustrating an example of a configuration of a semiconductor manufacturing system according to the embodiment.
FIG. 11 is a block diagram illustrating an example of a configuration of an exposure apparatus according to the embodiment.
FIG. 12 is a block diagram illustrating an example of a configuration of a bonding apparatus according to the embodiment.
FIG. 13 is a block diagram illustrating an example of a configuration of a server according to the embodiment.
FIG. 14 is a schematic diagram illustrating an outline of a method for manufacturing a semiconductor device according to the embodiment.
FIG. 15 is a schematic diagram illustrating examples of arrangement of alignment marks used in a semiconductor device manufacturing process according to the embodiment.
FIG. 16 is a table illustrating an example of correction performance of overlay deviation components in a wafer surface in the exposure apparatus and the bonding apparatus that are used in the semiconductor device manufacturing process according to the embodiment.
FIG. 17 is a graph illustrating an example of relationship between a wafer warpage amount XY difference and a wafer magnification XY difference.
FIG. 18 is a flowchart illustrating an example of a process for forming a film stress adjustment layer included in the semiconductor device manufacturing process according to the embodiment.
FIGS. 19 to 21 are a schematic diagrams illustrating an example of a structure in formation of the film stress adjustment layer of the semiconductor device according to the embodiment.
FIG. 22 is a flowchart illustrating an example of an exposure method of the exposure apparatus according to the embodiment.
FIG. 23 is a graph illustrating an example of a correction formula used in the exposure apparatus according to the embodiment.
FIG. 24 is a flowchart illustrating an example of a method for creating the correction formula used in the exposure apparatus according to the embodiment.
FIG. 25 is a schematic diagram illustrating a specific example of the method for creating the correction formula used in the exposure apparatus according to the embodiment.
FIG. 26 is a schematic diagram illustrating an example of change of a wafer magnification in a case where a shrinkable film is used in the film stress adjustment layer of the semiconductor device according to the embodiment.
FIG. 27 is a schematic diagram illustrating an example of change of the wafer magnification in a case where an expandable film is used in the film stress adjustment layer of the semiconductor device according to the embodiment.
FIG. 28 is a schematic diagram illustrating an example of adjustment of the wafer magnification in the method for manufacturing a semiconductor device according to the embodiment.

### DETAILED DESCRIPTION

An exposure apparatus according to one embodiment is configured to expose a substrate to light. The exposure apparatus includes a light source, a stage and a control device. The stage is configured to hold the substrate to be exposed. The control device is configured to correct exposure amount of light. The control device is configured to: calculate magnification components in a first direction and a second direction , based on measurement results of at least three alignment marks, the first direction and the second direction crossing each other and parallel with a surface of the substrate; and correct exposure amount based on a value of a difference between the magnification component of the first direction and the magnification component of the second direction.

Hereinafter, an embodiment will be described with reference to the drawings. The embodiment exemplifies an apparatus and a method for embodying the technical concepts of the invention. The drawings are schematic or conceptual. Dimensions, ratios, and the like of each drawing are not necessarily the same as the actual dimensions, ratios, and the like. Where appropriate, illustrations of configurations are omitted. The hatching added to the drawings is not necessarily related to the materials or characteristics of constituent elements. In the present specification, constituent elements having substantially the same functions and configurations have the same reference signs assigned thereto. Numerals and the like appended to the reference signs are referred to using the same reference signs and are used to distinguish between similar elements.

### <1> Specific example of semiconductor device

The semiconductor device of the present specification is formed by bonding two semiconductor circuit substrates (wafers) each having a semiconductor circuit formed thereon, and by dividing the bonded semiconductor circuit substrates into chips. Examples of the semiconductor device having such a bonding structure include a memory device capable of storing data in a nonvolatile manner. The following is an explanation of an example of a configuration of a memory device having a bonding structure, as a specific example of the semiconductor device.

### <1-1> Whole configuration of memory device 10

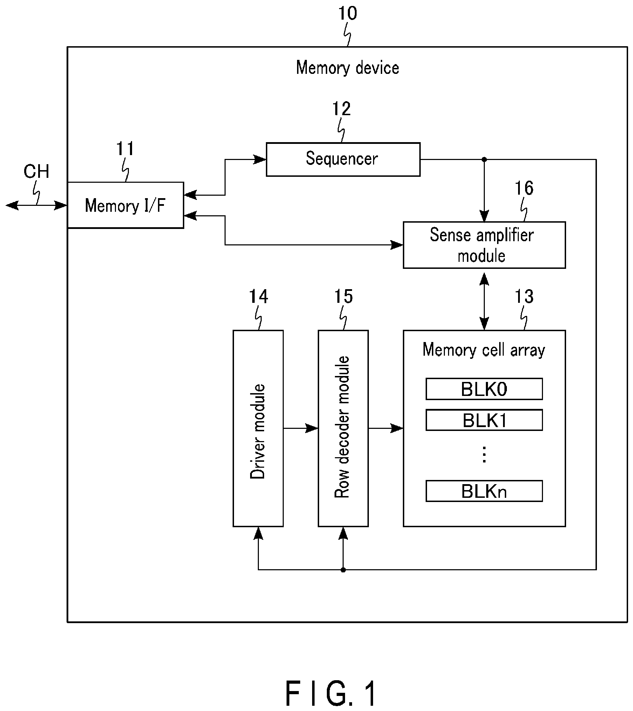

FIG. 1 is a block diagram illustrating an example of a whole configuration of a memory device 10 according to an embodiment. As illustrated in FIG. 1, the memory device 10 includes, for example, a memory interface (memory I/F) 11, a sequencer 12, a memory cell array 13, a driver module 14, a row decoder module 15, and a sense amplifier module 16.

The memory I/F 11 is a hardware interface connected to an external memory controller via a channel CH. The memory I/F 11 executes communications according to an interface standard between the memory device 10 and the memory controller. The memory I/F 11 supports, for example, the NAND interface standard.

The sequencer 12 is a control circuit controlling the whole operation of the memory device 10. The sequencer 12 controls the driver module 14, the row decoder module 15, and the sense amplifier 16 and the like based on a command received via the memory I/F 11 to execute a read operation, a write operation, and an erase operation, and the like.

The memory cell array 13 is a storage circuit including a set of a plurality of memory cells. The memory cell array 13 includes a plurality of blocks BLK0 to BLKn (n is an integer of 1 or more). Each of the blocks BLK is used as, for example, a data erase unit. The memory cell array 13 is provided with a plurality of bit lines and a plurality of word lines. Each of the memory cells is associated with, for example, one of the bit lines BL and one of the word lines WL. Each of the memory cells is identified based on an address identifying the word line WL and an address identifying the bit line BL.

The driver module 14 is a driver circuit generating voltages used in a read operation, a write operation, and an erase operation and the like. The driver module 14 is connected to the row decoder module 15 via a plurality of signal lines. The driver module 14 is capable of varying the voltage to be applied to each of the signal lines based on the page address received via the memory I/F 11.

The row decoder module 15 is a decoder that decodes a row address received via the memory I/F 11. The row decoder module 15 selects one block BLK based on a decoding result. The row decoder module 15 transfers voltages applied to the respective signal lines to respective lines (such as word lines WL) provided to the selected block BLK.

The sense amplifier module 16 is a sense circuit that senses data read from the selected block BLK based on the voltage of the bit line BL in a read operation. The sense amplifier module 16 transmits the read data to the memory controller via the memory I/F 11. In a write operation, the sense amplifier module 16 is capable of applying the voltage corresponding to the data to be written to the memory cell for each bit line BL.

### <1-2> Circuit configuration of memory cell array 13

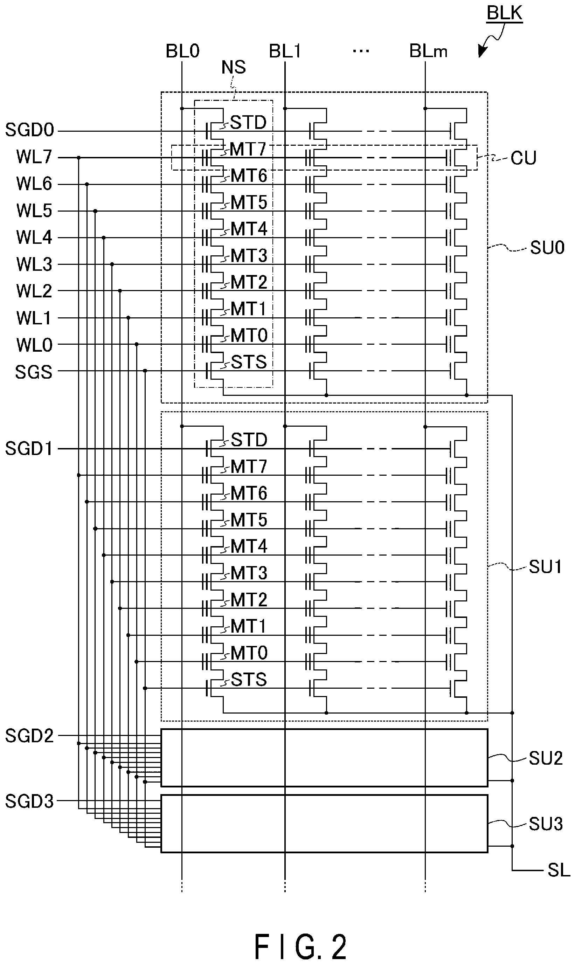

FIG. 2 is a circuit diagram illustrating an example of a circuit configuration of the memory cell array 13 included in the memory device 10 according to the embodiment. FIG. 2 illustrates a block BLK in a plurality of blocks BLK included in the memory cell array 13. As illustrated in FIG. 2, the block BLK includes, for example, four string units SU0 to SU3.

Each of the string units SU includes a plurality of NAND strings NS. The NAND strings NS are associated with bit lines BL0 to BLm (m is an integer of 1 or more), respectively. Mutually different column addresses are assigned to the respective bit lines BL0 to BLm. Each bit line BL is shared by the NAND strings NS to which the same column address is allocated among the blocks BLK. Each NAND string NS includes, for example, memory cell transistors MT0 to MT7 and select transistors STD and STS.

Each memory cell transistor MT includes a control gate and a charge storage layer, and stores data in a nonvolatile manner. The memory cell transistors MT0 to MT7 of each NAND string NS are connected in series. The control gates of the memory cell transistors MT0 to MT7 are connected to the word lines WL0 to WL7, respectively. Each of the word lines WL0 to WL7 is provided for each block BLK. A set of a plurality of memory cell transistors MT connected to the common word line WL in the same string unit SU is referred to as, for example, "cell unit CU". If each memory cell transistor MT stores 1-bit data, the cell unit CU stores "1-page data". The cell unit CU may have a storage capacity of two page data or more according to the number of bits of data stored by the memory cell transistor MT.

Each of the select transistors STD and STS is used to select the string unit SU. The drain of the select transistor STD is connected to the associated bit line BL. The source of the select transistor STD is connected to one end of the memory cell transistors MT0 to MT7 connected in series. Gates of the select transistors STD included in the string units SU0 to SU3 are connected to select gate lines SGD0 to SGD3, respectively. The drain of the select transistor STS is connected to the other end of the memory cell transistors MT0 to MT7 connected in series. The source of the select transistor STS is connected to the source line SL. The gate of the select transistor STS is connected to the select gate line SGS. The source line SL is shared by a plurality of blocks BLK, for example.

### <1-3> Structure of memory device 10

Hereinafter, an example of the structure of the memory device 10 according to the embodiment will be described. Note that, in the present specification, an X direction and a Y direction are directions crossing each other and parallel with a surface of the semiconductor substrate. A Z direction is a direction crossing each of the X direction and the Y direction, and corresponds to a vertical direction with respect to the surface of the semiconductor substrate used to form the memory device 10. For example, the X direction corresponds to the direction of extension of the word lines WL, and the Y direction corresponds to the direction of extension of the bit lines BL. In the present specification, "up and down" is defined on the basis of the direction extending along the Z direction. In the following explanation, the upper side and the lower side in the drawing correspond to "upper" and "lower", respectively.

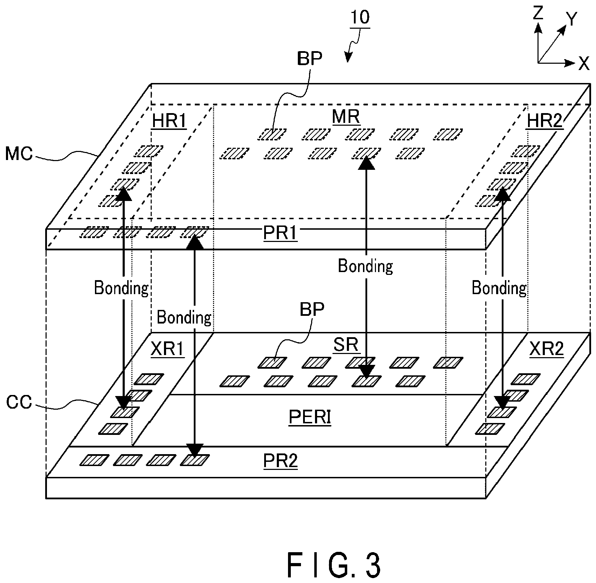

FIG. 3 is a perspective view illustrating an example of a structure of the memory device 10 according to the embodiment. As illustrated in FIG. 3, the memory device 10 includes a memory chip MC and a CMOS chip CC. The memory chip MC includes, for example, a memory region MR, hookup regions HR1 and HR2, and a pad region PR1. The CMOS chip CC includes, for example, a sense amplifier region SR, a peripheral circuit region PERI, transfer regions XR1 and XR2, and a pad region PR2.

The memory region MR includes the memory cell array 13. The hookup regions HR1 and HR2 include an interconnect or the like that is used for interconnecting the stacked interconnect provided to the memory chip MC and the row decoder module 15 provided to the CMOS chip CC. The pad region PR1 includes a pad or the like that is used for a connection between the memory device 10 and the memory controller. The hookup regions HR1 and HR2 sandwich the memory region MR in the X direction. The pad region PR1 is adjacent, in the Y direction, to the memory region MR and each of the hookup regions HR1 and HR2.

The sense amplifier region SR includes the sense amplifier module 16. The peripheral circuit region PERI includes the sequencer 12, the driver module 14, and the like. The transfer regions XR1 and XR2 include the row decoder module 15. The pad region PR2 includes the memory I/F 11. The sense amplifier region SR and the peripheral circuit region PERI are arranged adjacent to each other in the Y direction and overlap the memory region MR. The transfer regions XR1 and XR2 sandwich a set of the sense amplifier region SR and the peripheral circuit region PERI in the X direction, and overlap the hookup regions HR1 and HR2, respectively. The pad region PR2 overlaps the pad region PR1 of the memory chip MC.

The memory chip MC includes a plurality of bonding pads BP in respective lower parts of the memory region MR, the hookup regions HR1 and HR2, and the pad region PR1, respectively. The bonding pads BP of the memory region MR are connected to the associated bit lines BL. The bonding pads BP of the hookup regions HR are connected to associated interconnect (for example, word lines WL) among the stacked interconnect provided to the memory region MR. The bonding pad BP of the pad region PR1 is connected to a pad (not illustrated) provided to the upper surface of the memory chip MC. The pad provided to the upper surface of the memory chip MC is used, for example, for connection between the memory device 10 and the memory controller.

The CMOS chip CC includes a plurality of bonding pads BP in respective upper parts of the sense amplifier region SR, the peripheral circuit region PERI, the transfer regions XR1 and XR2, and the pad region PR2. The bonding pads BP of the sense amplifier region SR overlap the bonding pads BP of the memory region MR. The bonding pads BP of the transfer regions XR1 and XR2 overlap the bonding pads BP of the hookup regions HR1 and HR2, respectively. The bonding pads BP of the pad region PR1 overlap the bonding pads BP of the pad region PR2.

The memory device 10 has a structure in which the lower surface (front surface of the semiconductor substrate on which the memory chip MC is formed) of the memory chip MC and the upper surface (front surface of the semiconductor substrate on which the CMOS chip CC is formed) of the CMOS chip CC are bonded to each other. Among the bonding pads BP provided to the memory device 10, two bonding pads BP facing each other between the memory chip MC and the CMOS chip CC are electrically connected through bonding. Thus, the circuit in the memory chip MC and the circuit in the CMOS chip CC are electrically connected via the bonding pads BP. A set of two bonding pads BP facing each other between the memory chip MC and the CMOS chip CC may have a boundary or may be integrated with one another.

### <1-3> Structure of memory cell array 13

The structure of the memory cell array 13 will be explained hereinafter.

### (Planar layout of memory cell array 13)

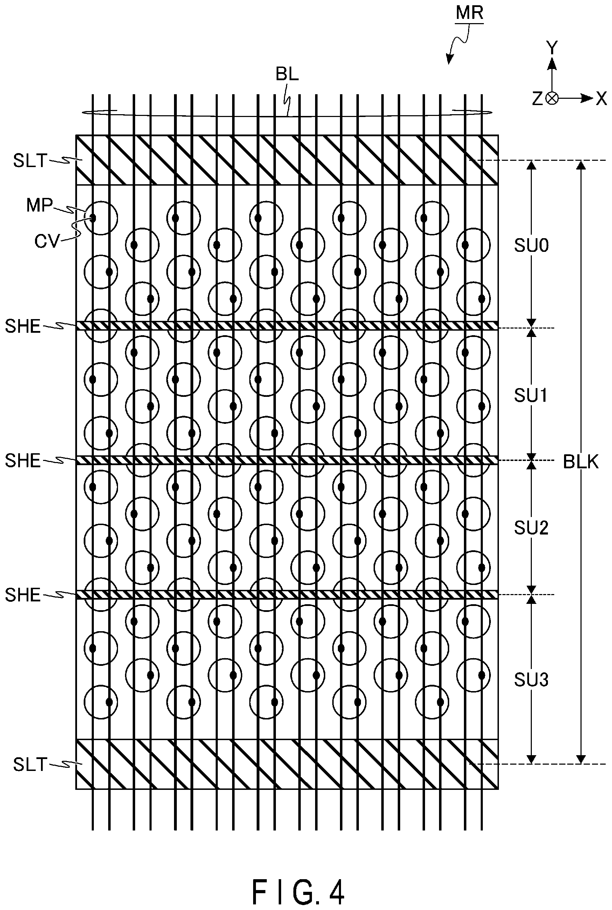

FIG. 4 is a plan view illustrating an example of a planar layout of the memory cell array 13 included in the memory device 10 according to the embodiment. FIG. 4 illustrates an area that includes one block BLK in the memory region MR. As illustrated in FIG. 4, the memory device 10 includes, for example, a plurality of slits SLT, a plurality of slits SHE, a plurality of memory pillars MP, a plurality of bit lines BL, and a plurality of contacts CV. In the memory region MR, a planar layout described below is repeatedly arranged in the Y direction.

Each slit SLT has, for example, a structure in which an insulating member is embedded. Each slit SLT insulates adjacent interconnects (for example, the word lines WL0 to WL7 and the select gate lines SGD and SGS) via the slit SLT. Each slit SLT has a portion that is provided to extend along the X direction and that crosses the memory region MR and the hookup regions HR1 and HR2, along the X direction. The slits SLT are arranged in the Y direction. The regions that are delimited by the slits SLT correspond to the blocks BLK.

Each slit SHE has, for example, a structure in which an insulating member is embedded. The slits SHE insulate adjacent interconnects (at least select gate line SGD) from each other via the slits SLT. Each slit SHE has a portion that is provided so as to extend along the X direction and that crosses the memory region MR. The slits SHE are arranged in the Y direction. In this example, three slits SHE are arranged between adjacent slits SLT. A plurality of regions partitioned by the slits SLT and SHE correspond to the string units SU0 to SU3, respectively.

Each memory pillar MP functions as, for example, one NAND string NS. The memory pillars MP are arranged in, for example, 19 rows in a staggered manner in a region between two adjacent slits SLT. Further, the respective slits SHE overlap the fifth row of the memory pillars MP, the tenth row of the memory pillars M, and the fifteenth row of the memory pillars MP, from the upper side of the drawing.

Each of the bit lines BL has a portion that is provided to extend along the Y direction, and that crosses a region where the blocks BLK are provided, along the Y direction. The bit lines BL are arranged in the X direction. Each bit line BL is arranged to overlap at least one memory pillar MP for each string unit SU. In this example, two bit lines BL overlap each memory pillar MP.

Each contact CV is provided between one bit line BL among the bit lines BL overlapping the memory pillar MP, and the memory pillar MP. The contact CV electrically connects the memory pillar MP and the bit line BL. Note that illustration of the contact CV between the memory pillar MP overlapping the slit SHE and the bit line BL is omitted.

### (Cross-sectional structure of memory cell array 13)

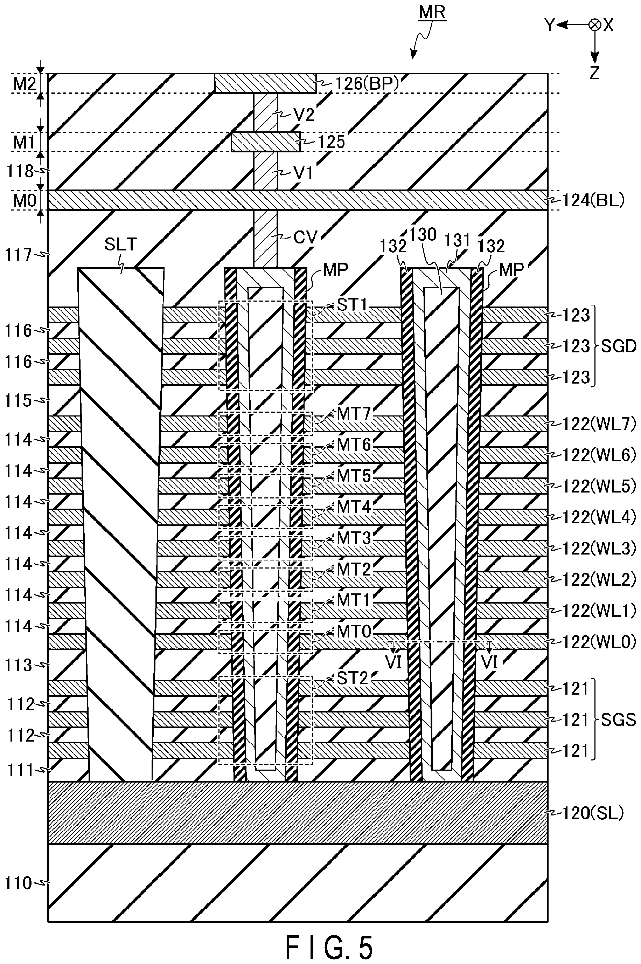

FIG. 5 is a cross-sectional view illustrating an example of a cross-sectional structure of the memory cell array 13 included in the memory device 10 according to the embodiment. FIG. 5 illustrates a cross-section taken along the Y direction and including the memory pillars MP and the slit SLT in the memory region MR. As illustrated in FIG. 5, the memory device 10 includes, for example, insulating layers 110 to 118, conductive layers 120 to 126, and contacts V1 and V2.

The insulating layer 110 is provided, for example, in the lowermost layer of the memory chip MC. The layer in which the insulating layer 110 is formed may be provided with an interconnect used for connection of the conductive layer 120 and/or the pad PD. The conductive layer 120 is provided on the insulating layer 110. The insulating layer 111 is provided on the conductive layer 120. The conductive layers 121 and the insulating layers 112 are alternately provided on the insulating layer 111. The insulating layer 115 is provided on the uppermost conductive layer 122. The conductive layers 123 and the insulating layers 116 are alternately provided on the insulating layer 115. The insulating layer 117 is provided on the uppermost conductive layer 123. The conductive layer 124 is provided on the insulating layer 117. The insulating layer 118 is provided on the conductive layer 124. The layer in which the insulating layer 118 is formed includes the contacts V1 and V2 and the conductive layers 125 and 126. The contact V1 is provided on the conductive layer 124. The conductive layer 125 is provided on the contact V1. The contact V2 is provided on the conductive layer 125. The conductive layer 126 is provided on the contact V2.

Each of the conductive layers 120, 121, 122, and 123 is formed in, for example, a plate shape that extends along the XY plane. The conductive layer 124 is formed in, for example, a line shape that extends in the Y direction. The conductive layers 120, 121, and 123 are used as a source line SL, a select gate line SGS, and a select gate line SGD, respectively. The conductive layers 123 are used as the word lines WL0 to WL7, respectively, in order from the lower side. The conductive layer 124 is used as the bit line BL. The conductive layers 124 and 125 are interconnected via the contact V1. The conductive layer 125 and the conductive layer 126 are interconnected via the contact V2. The conductive layer 126 is in contact with the interface of the memory chip MC and is used as a bonding pad BP. The conductive layer 126 includes copper, for example.

The slit SLT has a portion formed in a plate shape that extends along the XZ plane, and divides the insulating layers 111 to 116 and the conductive layers 121 to 123. Each memory pillar MP is provided to extend along the Z direction, and extends through the insulating layers 111 to 116 and the conductive layers 121 to 123. Each memory pillar MP includes, for example, a core member 130, a semiconductor layer 131, and a stacked film 132. The core member 130 is an insulator provided to extend along the Z direction. The semiconductor layer 131 covers the core member 130. A lower portion of the semiconductor layer 131 is in contact with the conductive layer 120. The stacked film 132 covers the lateral surface of the semiconductor layer 131. The contact CV is provided on the semiconductor layer 131. The semiconductor layer 131 is electrically connected to the conductive layer 124 via the contact CV.

Note that, the illustrated region illustrates the contact CV corresponding to one memory pillar MP of the two memory pillars MP. A contact CV is connected, in a region (not illustrated), to the memory pillar MP to which the contact CV is not connected in the region. A portion where the memory pillar MP intersects the conductive layers 61 functions as the select transistor STS. The portion where the memory pillar MP intersects the conductive layer 122 functions as the memory cell transistor MT. The portion where the memory pillar MP intersects the conductive layers 123 functions as the select transistor STD. In the following explanation, the interconnect layer portions including the conductive layers 124, 125, and 126 are referred to as "M0", "M1", and "M2", respectively.

### (Cross-sectional structure of memory pillar MP)

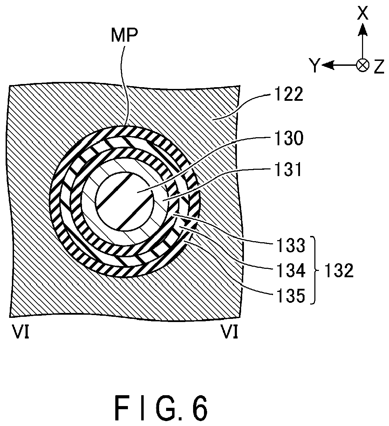

FIG. 6 is a cross-sectional view taken along line VI-VI in FIG. 5, illustrating an example of a cross-sectional structure of the memory pillar MP included in the memory device 10 according to the embodiment. FIG. 6 illustrates a cross-section that includes the memory pillar MP and the conductive layer 122 and that extends parallel to the X direction and the Y direction. As illustrated in FIG. 5, the stacked film 132 includes, for example, a tunnel insulating film 133, an insulating film 134, and a block insulating film 135.

The core member 130 is provided, for example, at the center portion of the memory pillar MP. The semiconductor layer 131 surrounds the lateral surface of the core member 130. The tunnel insulating film 133 surrounds the lateral surface of the semiconductor layer 131. The insulating film 134 surrounds the lateral surface of the tunnel insulating film 133. The block insulating film 135 surrounds the lateral surface of the insulating film 134. The conductive layer 122 surrounds the lateral surface of the block insulating film 135. The semiconductor layer 131 is used as a channel (current path) of the memory cell transistors MT0 to MT7 and the select transistors STD and STS. Each of the tunnel insulating film 133 and the block insulating film 135 contains, for example, silicon oxide (SiO₂). The insulating film 134 is used as the charge storage layer of the memory cell transistor MT, and includes, for example, silicon nitride (SiN). As a result, each of the memory pillars MP functions as one NAND string NS.

### <1-3-2> Cross-sectional structure of memory device 10

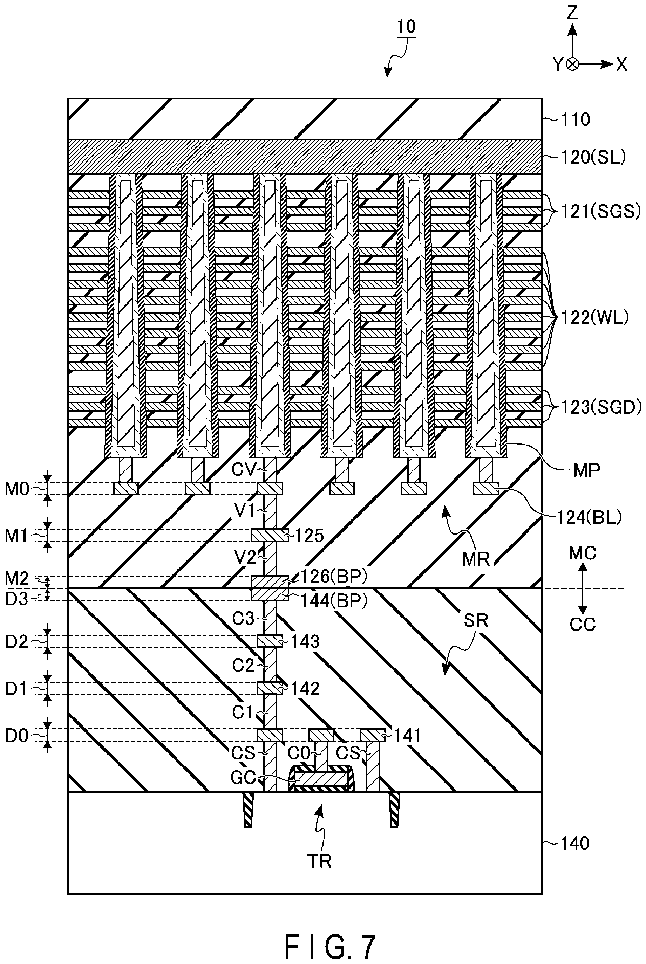

FIG. 7 is a cross-sectional view illustrating an example of a cross-sectional structure of a memory device 10 according to the embodiment. FIG. 7 illustrates a cross-section that includes the memory region MR and the sense amplifier region SR, that is, a cross-section including the memory chip MC and the CMOS chip CC. As illustrated in FIG. 7, the memory device 10 includes a semiconductor substrate 140, conductive layers GC and 141 to 144, and contacts CS and C0 to C3 in the sense amplifier region SR.

The semiconductor substrate 140 is a substrate that is used to form the CMOS chip CC. The semiconductor substrate 140 includes a plurality of well regions (not illustrated). For example, a transistor TR is formed in each of the plurality of well regions. The plurality of well regions are separated by shallow trench isolations (STI), for example. A conductive layer GC is provided on the semiconductor substrate 140 via a gate insulating film. The conductive layer GC in the sense amplifier region SR is used as a gate electrode of the transistor TR included in the sense amplifier module 16. The contact C0 is provided on the conductive layer GC. Two contacts CS are provided on the semiconductor substrate 140 in correspondence with the source and the drain of the transistor TR.

The conductive layer 141 is provided on each of the contacts CS and the contact C0. The contact C1 is provided on the conductive layer 141. The conductive layer 142 is provided on the contact C1. The conductive layers 141 and 142 are electrically connected via the contact C1. The contact C2 is provided on the conductive layer 142. The conductive layer 143 is provided on the contact C2. The conductive layers 142 and 143 are electrically connected via the contact C2. The contact C3 is provided on the conductive layer 143. The conductive layer 144 is provided on the contact C3. The conductive layers 143 and 144 are electrically connected via the contact C3. Hereinafter, the interconnect layers in which the conductive layers 141 to 144 are provided are referred to as "D0", "D1", "D2", and "D3", respectively.

The conductive layer 144 is in contact with the interface of the CMOS chip CC and is used as a bonding pad BP. The conductive layer 144 in the sense amplifier region SR is bonded to the conductive layer 126 (that is, the bonding pad BP of the memory chip MC) in the memory region MR that is arranged to face the conductive layer 144. Further, each conductive layer 144 in the sense amplifier region SR is electrically connected to one bit line BL. The conductive layer 144 includes copper, for example. In the memory device 10, the interconnect layer D3 of the CMOS chip CC and the interconnect layer M2 of the memory chip MC are adjacent to each other due to the memory chip MC and the CMOS chip CC being bonded to each other.

In the present example, the semiconductor substrate used to form the memory chip MC is removed along with processes, such as pad formation after the bonding process. The semiconductor substrate used to form the memory chip MC may be left. The number of interconnect layers of each of the memory chip MC and the CMOS chip CC is not limited to the number explained above. The number of interconnect layers of each of the memory chip MC and the CMOS chip CC may properly be changed according to the configuration of the memory device 10.

### <1-3-3> Structure of film stress adjustment layer AL

The memory device 10 according to the embodiment includes a film stress adjustment layer AL. The film stress adjustment layer AL is a structure provided to suppress warpage of the semiconductor substrate. The film stress adjustment layer AL is formed by a method for manufacturing a semiconductor device described later, and properly provided in a position where no interconnects or devices connected to the circuit are provided, in the memory device 10. The film stress adjustment layer AL may be included in the interconnect layer. The film stress adjustment layer AL is included, for example, in the interconnect layer M1 in the Z direction. The structure is not limited thereto, but the film stress adjustment layer AL may be provided at another height or may be provided in either of the memory chip MC and the CMOS chip CC. The following is an explanation of an example of the structure of the film stress adjustment layer AL.

### (Planar layout of film stress adjustment layer AL)

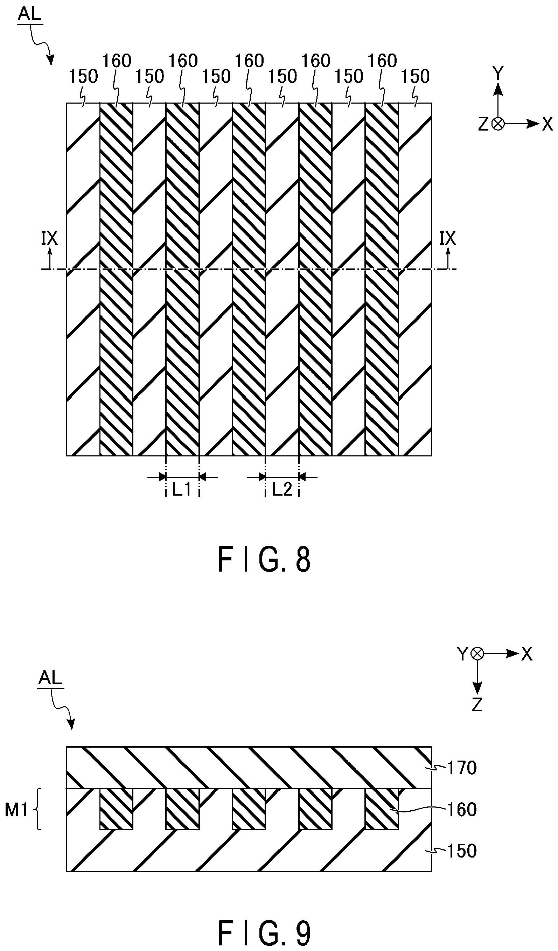

FIG. 8 is a plan view illustrating an example of a planar layout of the film stress adjustment layer AL included in the memory device 10 according to the embodiment. As illustrated in FIG. 8, the film stress adjustment layer AL includes, for example, a plurality of insulating layers 150 and a plurality of stress adjustment members 160.

The insulating layers 150 are insulators used for formation of the film stress adjustment layer AL. The stress adjustment members 160 are members provided in portions acquired by processing the insulating layers 150. Each of the stress adjustment members 160 is one of a shrinkable film having shrinkage characteristics and an expandable film having expansibility. A shrinkable film is a film of compressive stress and an expandable film is a film of tensile stress. For example, tungsten (W) or silicon nitride (SiN) or the like is used as the stress adjustment member 160 serving as a shrinkable film. For example, SiOz or the like is used as the stress adjustment member 160 serving as an expandable film. In the following explanation, the stress adjustment member 160 serving as a shrinkable film is also referred to as "stress adjustment member 160a". The stress adjustment member 160 serving as an expandable film is also referred to as "stress adjustment member 160b". The stress adjustment member 160 may also be simply referred to as "member".

Each of the insulating layers 150 includes a portion provided to extend in the Y direction. The portions of the insulating layers 150 provided to extend in the Y direction are arranged at substantially regular intervals in the X direction. Each of the stress adjustment members 160 includes a portion provided to extend in the Y direction. The portions of the stress adjustment members 160 provided to extend in the Y direction are arranged at substantially regular intervals in the X direction. The portions of the insulating layers 150 provided to extend in the Y direction and the portions of the stress adjustment members 160 provided to extend in the Y direction are alternately arranged in the X direction and in contact with each other.

The portions of the insulating layers 150 provided to extend in the Y direction are provided to have a substantially equal width. The portions of the stress adjustment members 160 provided to extend in the Y direction are provided to have a substantially equal width. In the following explanation, the size (width) of the portions of the stress adjustment members 160 provided to extend in the Y direction is referred to as "L1". The size (width) of the portions of the insulating layers 150 provided to extend in the Y direction is referred to as "L2". Each of the values of "L1" and "L2" may properly be changed according to exposure process of the exposure apparatus 20 according to the embodiment described later.

### (Cross-section of film stress adjustment layer AL)

FIG. 9 is a cross-sectional view taken along line IX-IX of FIG. 8 and illustrating an example of a cross-sectional structure of the film stress adjustment layer AL included in the memory device 10 according to the embodiment. As illustrated in FIG. 9, the film stress adjustment layer AL further includes, for example, an insulating layer 170. In the present example, the insulating layers 150 and 170 are included in the insulating layer 118 illustrated in FIG. 5.

The insulating layers 150 are successively provided under the interconnect layer M1. Specifically, in the film stress adjustment layer AL, a plurality of trench portions are provided in the upper portion of the insulating layers 150. The stress adjustment members 160 are embedded in the respective trench portions of the insulating layers 150. Thereafter, the insulating layer 170 is provided to cover the insulating layers 150 and the stress adjustment members 160. In a case where such a structure is provided in the film stress adjustment layer AL, the upper surfaces of the insulating layers 150 are aligned with the upper surfaces of the stress adjustment members 160.

The insulating layers 150 are not necessarily include portions that are successively provided under the interconnect layer M1. The stress adjustment members 160 and the insulating layer 170 may be provided as one unitary piece. It suffices that the film stress adjustment layer AL includes a plurality of stress adjustment members 160 arranged at regular intervals. The heights of bottom portions of the stress adjustment members 160 are equal because they are formed together. As long as it is possible to adjust film stress as described later, parts of the adjacent stress adjustment members 160 in the layers of the same height may be in contact with each other.

The explanation described above illustrates the case where portions of the stress adjustment members 160 extending in the Y direction are arranged side by side in the X direction, but the structure is not limited thereto. The memory device 10 may have a structure in which the structure of the film stress adjustment layer AL illustrated in FIG. 8 and FIG. 9 is rotated by 90° in plan view. It suffices that the film stress adjustment layer AL includes at least one of a plurality of stress adjustment members 160 having portions extending in the Y direction and arranged at regular intervals in the X direction, and a plurality of stress adjustment members 160 having portions extending in the X direction and arranged at regular intervals in the Y direction.

### <2> Configuration of semiconductor manufacturing system PS

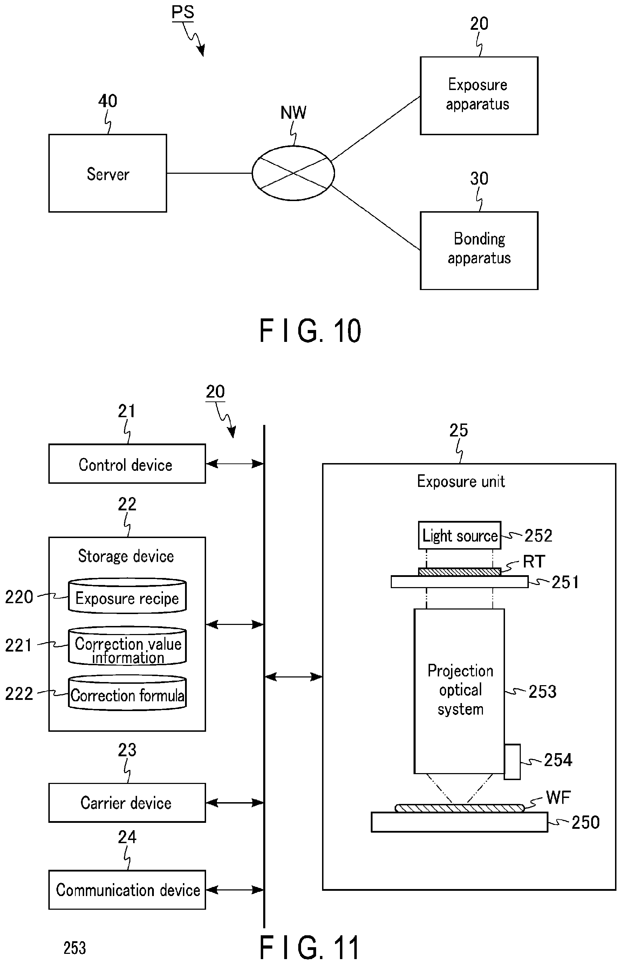

The following is an explanation of a semiconductor manufacturing system PS used to form the semiconductor device (for example, memory device 10) including the film stress adjustment layer AL. FIG. 10 is a block diagram illustrating an example of a configuration of the semiconductor manufacturing system PS according to the embodiment. As illustrated in FIG. 10, the semiconductor manufacturing system PS includes, for example, an exposure apparatus 20, a bonding apparatus 30, and a server 40.

The exposure apparatus 20, the bonding apparatus 30, and the server 40 are configured to be capable of communicating via a network NW. Wired communication or wireless communication may be used for the network NW. The exposure apparatus 20 has a function for transferring (exposing to light) a pattern formed on a mask (reticle) to a resist material formed on a wafer. The bonding apparatus 30 has a function for bonding two associated wafers. The server 40 is, for example, a computer or the like that controls the overall semiconductor device manufacturing process. The server 40 manages correction values that are used in a lot processing process and in each manufacturing process, and the like. Note that the semiconductor manufacturing system PS can also include an overlay measurement device or the like.

In the following explanation, the process in which the exposure apparatus 20 transfers the pattern of the mask to the resist material is referred to as "exposure process". The process for bonding two wafers is referred to as "bonding process". The wafer disposed on the upper side in the bonding process is referred to as "upper wafer UW". The wafer disposed on the lower side in the bonding process is referred to as "lower wafer LW". The bonded two wafers, that is, a pair of the upper wafer UW and the lower wafer LW is referred to as "bonded wafer BW". The element "front surface of the wafer" corresponds to the surface on which the semiconductor circuit is formed. The element "back surface of the wafer" corresponds to a surface on the reverse side of the front surface of the wafer.

### <2-1> Configuration of exposure apparatus 20

FIG. 11 is a block diagram illustrating an example of a configuration of the exposure apparatus 20 according to the embodiment. As illustrated in FIG. 11, the exposure apparatus 20 includes, for example, a control device 21, a storage device 22, a carrier device 23, a communication device 24, and an exposure unit 25.

The control device 21 is a computer or the like that controls the overall operation of the exposure apparatus 20. The control device 21 controls each of the storage device 22, the carrier device 23, the communication device 24, and the exposure unit 25. Although not illustrated, the control device 21 is equipped with a central processing unit (CPU), a read only memory (ROM), a random access memory (RAM), and the like. The CPU is a processor that executes various programs relating to the control of devices. The ROM is a nonvolatile storage medium that stores a device control program. The RAM is a volatile storage medium that is used as a work area of the CPU.

The storage device 22 is a storage medium that is used for storing data, programs, and the like. The storage device 22 stores, for example, an exposure recipe 220, correction value information 221, and a correction formula 222. The exposure recipe 220 is a table recording the setting of the exposure process. The exposure recipe 220 includes information such as the shot shape and layout, an exposure amount (dose), a focus setting, and an alignment setting. The correction value information 221 is a log that records alignment correction values (that is, alignment results) that are used when an exposure process is executed. The correction formula 222 is a numerical formula to adjust the exposure amount on the basis of the alignment results. Details of the correction formula 222 will be described later.

The carrier device 23 is a device that is equipped with a carrier arm capable of carrying a wafer WF, a transition for temporarily placing a plurality of wafers, and the like. For example, the carrier device 23 carries the wafer WF received from an external coating-development device to the exposure unit 25, for example. In addition, after the exposure process, the carrier device 23 carries the wafer WF received from the exposure unit 25 to the outside of the exposure apparatus 20.

The communication device 24 is a communication interface capable of connecting to the network NW. The exposure apparatus 20 may operate based on an operation by a terminal on the network NW, or may store the exposure recipe 220, the correction value information 221, and the correction formula 222 in the server 40.

The exposure unit 25 is a set of constituent elements used in the exposure process. The exposure unit 25 includes, for example, a wafer stage 250, a reticle stage 251, a light source 252, a projection optical system 253, and a camera 254. The wafer stage 250 has a function for holding a wafer WF. The reticle stage 251 has a function for holding a reticle RT (mask). The respective stage positions of the wafer stage 250 and the reticle stage 251 can be controlled based on control by the control device 21. The light source 252 irradiates the reticle RT with generated light. The projection optical system 253 collects the light transmitted through the reticle RT onto the surface of the wafer WF. The camera 254 is an imaging mechanism that is used to measure the alignment marks AM.

The element "coating-development device" is a device executing a pre-process and a post-process of the exposure process. The pre-process of the exposure process includes a process for coating the wafer with a resist material (photosensitive material). The post-process of the exposure process includes a process for developing a pattern with which the wafer is exposed. Note that a plurality of semiconductor manufacturing devices may also be used as devices used in the pre-process and the post-process of the exposure process.

### <2-2> Configuration of bonding apparatus 30

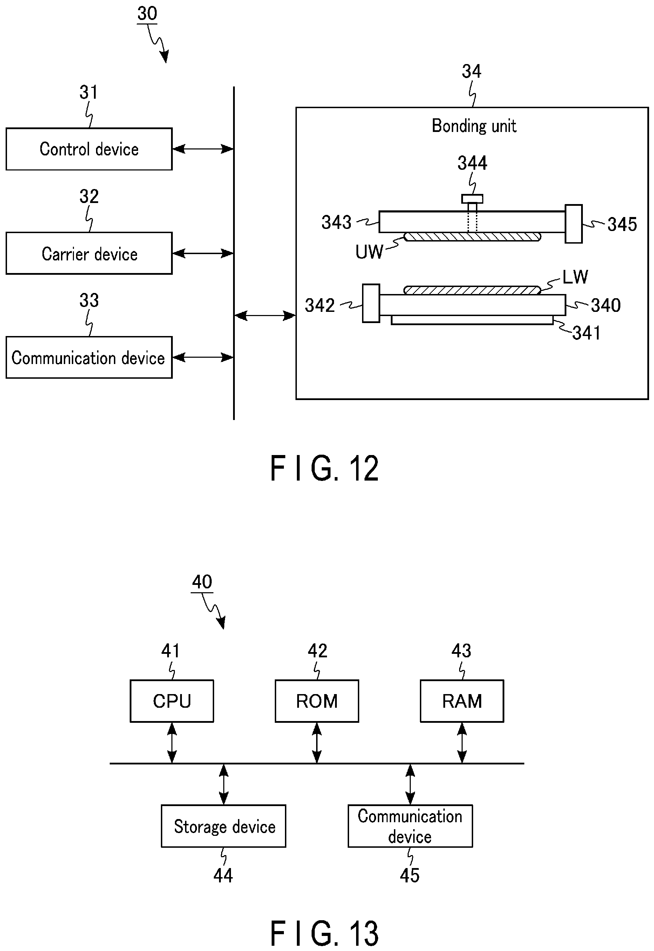

FIG. 12 is a block diagram illustrating an example of a configuration of the bonding apparatus 30 according to the embodiment. As illustrated in FIG. 12, the bonding apparatus 30 includes, for example, a control device 31, a carrier device 32, a communication device 33, and a bonding unit 34.

The control device 31 is a computer or the like that controls the overall operation of the bonding apparatus 30. The control device 31 controls each of the carrier device 32, the communication device 33, and the bonding unit 34. Although not illustrated, the control device 31 is equipped with a CPU, a ROM, a RAM, and the like, similarly to the exposure apparatus 20.

The carrier device 32 is a device that is equipped with a carrier arm capable of carrying a wafer, and a transition for temporarily placing a plurality of wafers, and the like. For example, the carrier device 32 carries the upper wafer UW and the lower wafer LW received from a pre-process device of the bonding process to the bonding unit 34. In addition, the carrier device 32 carries the bonded wafer BW received from the bonding unit 34 to the outside of the bonding apparatus 30 after the bonding process. The carrier device 32 may include a mechanism for vertically inverting the wafer.

The communication device 33 is a communication interface capable of connecting to the network NW. The bonding apparatus 30 may operate based on control of a terminal on the network NW, or may store an operation log on the server 40.

The bonding unit 34 is a set of constituent elements used in the bonding process. The bonding unit 34 includes, for example, a lower stage 340, a stress device 341, a camera 342, an upper stage 343, a pushpin 344, and a camera 345. The lower stage 340 has a function for holding the lower wafer LW. The lower stage 340 includes, for example, a wafer chuck that holds the wafer through vacuum suction. The stress device 341 has a function for applying stress to the lower stage 340 and for deforming the lower wafer LW via the lower stage 340. The expansion amount (scaling) of the lower wafer LW held by the lower stage 340 changes according to the amount of deformation of the lower stage 340 by the stress device 341. The camera 342 is an imaging mechanism that is disposed on the lower stage 340 side and used to measure the alignment marks AM of the upper wafer UW. The upper stage 343 has a function for holding the upper wafer UW. The upper stage 343 includes, for example, a wafer chuck that holds the wafer through vacuum suction. The pushpin 344 is a pin that can be driven in the up-down direction based on the control of the control device 31 to press the upper surface of the center portion of the upper wafer UW held by the upper stage 343. The camera 345 is an imaging mechanism that is disposed on the upper stage 343 side and used to measure the alignment marks AM of the lower wafer LW. The bonding apparatus 30 may have a vacuum pump that is used for vacuum suction of the lower stage 340 and the upper stage 343.

The lower stage 340 and the upper stage 343 are configured such that the lower wafer LW held by the lower stage 340 and the upper wafer UW held by the upper stage 343 can be arranged to face each other. That is, the upper stage 343 can be disposed above the lower stage 340. In the bonding process, the upper surface of the upper wafer UW is the back surface of the upper wafer UW and is held on the upper stage 343. In the bonding process, the lower surface of the upper wafer UW is a front surface of the upper wafer UW and corresponds to the bonding surface. The upper surface of the lower wafer LW is the front surface of the lower wafer LW and corresponds to the bonding surface. The lower surface of the lower wafer LW is the back surface of the lower wafer LW and is held by the lower stage 340. The bonding apparatus 30 is capable of adjusting a shift component and a rotation component of the overlay deviation by adjusting the relative positions of the lower stage 340 and the upper stage 343. The bonding apparatus 30 is also capable of adjusting the XY common wafer magnification of the lower wafer LW held by the deformed lower stage 340 by using the stress device 341 to deform the lower stage 340.

The above-mentioned "bonding-process pre-process device" is a device having a function for modifying and hydrophilizing the bonding surfaces of the upper wafer UW and the lower wafer LW to enable bonding, before the bonding process by the bonding apparatus 30. The pre-process device first performs a plasma process on the respective surfaces of the upper wafer UW and the lower wafer LW and modifies the respective surfaces of the upper wafer UW and the lower wafer LW. In the plasma process, oxygen ions or nitrogen ions are generated based on oxygen gas or nitrogen gas serving as the treatment gas, under a predetermined reduced atmosphere, and the generated oxygen ions or nitrogen ions are applied to the bonding surface of each wafer. Thereafter, the pre-process device supplies pure water to the respective surfaces of the upper wafer UW and the lower wafer LW. Thereupon, hydroxyl groups adhere to the respective surfaces of the upper wafer UW and the lower wafer LW, and the surfaces are hydrophilized. In the bonding process, the upper wafer UW and the lower wafer LW, the bonding surfaces of which have been modified and hydrophilized as described above, are used. The bonding apparatus 30 may be combined with a pre-process device or the like to form a bonding system.

### <2-3> Configuration of server 40

FIG. 13 is a block diagram illustrating an example of a configuration of the server 40 according to the embodiment. As illustrated in FIG. 13, the server 40 includes, for example, a CPU 41, a ROM 42, a RAM 43, a storage device 44, and a communication device 45. The CPU 41 is a processor that executes various programs relating to control of the server 40. The ROM 42 is a nonvolatile storage device that stores a control program of the server 40. The RAM 43 is a volatile storage device that is used as a work area of the CPU 41. The storage device 44 is a nonvolatile storage medium that is capable of storing information received from the exposure apparatus 20, the bonding apparatus 30, or the like. The communication device 45 is a communication interface capable of connecting to the network NW.

### <3> Method for manufacturing semiconductor device

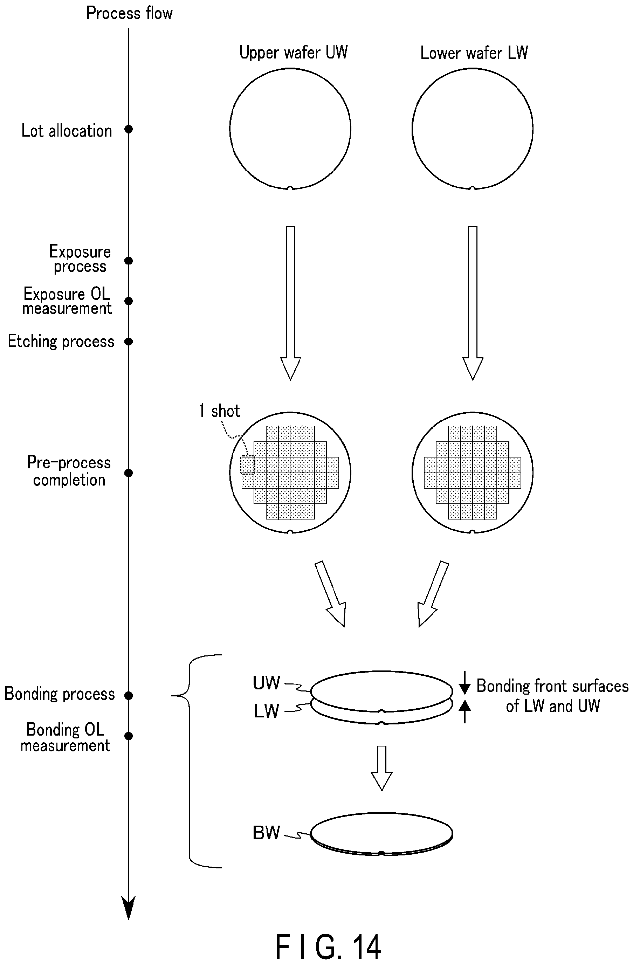

Hereinafter, a method for manufacturing a semiconductor device according to the embodiment will be described. FIG. 14 is a schematic diagram illustrating an outline of a method for manufacturing a semiconductor device according to the embodiment. The following is an explanation of approximate process flow of the method for manufacturing a semiconductor device according to the embodiment, with reference to FIG. 14.

First, a wafer is allocated to a lot ("lot allocation"). A lot may include a plurality of wafers. Lots may be categorized into lots including the upper wafer UW and lots including the lower wafer LW, for example. Thereafter, a pre-process is performed on each of the lots including the upper wafer UW and the lots including the lower wafer LW, and a semiconductor circuit is formed on each of the upper wafer UW and the lower wafer LW. A pre-process includes a combination of "exposure process", "exposure OL (overlay) measurement", and "etching process".

The exposure process is, for example, a process for transferring a mask pattern to a wafer for each shot. The "shot" corresponds to a segregated region of exposure in the exposure process. In the exposure process, one-shot exposure is repeatedly executed with the exposure position shifted. That is, the exposure apparatus 20 executes the exposure process using a step-and-repeat method. In the exposure process, the arrangement and shape of each shot are corrected based on measurement results for the alignment marks, which will be described later, and of various correction values, and the like, and the position of overlay with the substrate pattern formed on the wafer is adjusted (aligned). The arrangement of the shots in the upper wafer UW and the arrangement of the plurality of shots in the lower wafer LW are set to be identical. Hereinafter, the correction values used in the alignment of the overlay position, that is, the control parameters of the exposure apparatus for suppressing the overlay deviation, are referred to as the "alignment correction values". In a case where a polynomial is used to correct the alignment, the coefficient of each term is referred to as an "alignment correction coefficient". That is, the alignment correction values can be calculated based on the alignment correction coefficient for each term and the exposure position.

The exposure OL measurement is a process for measuring overlay deviation amounts between a pattern formed by the exposure process and a pattern serving as the substrate in the exposure process. The measurement results of the overlay deviation amounts obtained through exposure OL measurement can be used in a determination to rework the exposure process, or to calculate alignment correction values that are to be applied to the subsequent lot, and the like. The etching process is a manufacturing process for etching the wafer by using a mask formed by the exposure process. When the etching process is completed, the used mask is removed and the next process is performed. The pre-process may include a heating process, a cleaning process, and/or a film formation process and the like, in addition to the exposure process, the exposure OL process, and the etching process.

When the pre-process is completed for each of the associated upper wafer UW and the lower wafer LW, a bonding process is performed. In the bonding process, the bonding apparatus 30 arranges the surface of the upper wafer UW and the surface of the lower wafer LW to face each other. Further, the bonding apparatus 30 adjusts (aligns) the position of overlay between the pattern formed on the front surface of the upper wafer UW and the pattern formed on the front surface of the lower wafer LW. Thereafter, the bonding apparatus bonds the front surfaces of the upper wafer UW and the lower wafer LW to form a bonded wafer BW.

Bond OL (overlay) measurement is performed on the bonded wafer BW formed by the bonding process. The bond OL measurement is a process.for measuring overlay deviation amounts between the pattern formed on the front surface of the upper wafer UW and the pattern formed on the front surface of the lower wafer LW. The measurement results of the overlay deviation amounts obtained through bond OL measurement can be used to calculate alignment correction values that are applied to the exposure process of the subsequent lot, and the like.

The overlay deviation amounts generated in the exposure process or the bonding process can be expressed by a combination of various components. The overlay deviation components include, for example, an offset (shift) component, a magnification component, and an orthogonality component. Formulae corresponding to the components are listed hereinbelow. Note that, in the following formulae, "x" and "y" correspond to a coordinate (X coordinate) in the X direction and a coordinate (Y coordinate) in the Y direction, respectively. The elements "dx" and "dy" are overlay deviation amounts in the X direction and the Y direction, respectively. "K1" to "K6" correspond to respective coefficients (polynomial regression coefficients) of overlay deviation components. An offset (shift) component in the X direction is "dx = K1". The offset (shift) component in the Y direction is "dy = K2". The magnification component in the X direction is "dx = K3·x". The magnification component in the Y direction is "dy = K4.y". An orthogonality component in the X direction is "dx = K5·y". An orthogonality component in the Y direction is "dy = K6.x".

In the present example, the overlay deviation amount Ex in the X direction is calculated by "Ex=K1+K3·x+dy+K5. The overlay deviation amount Ey in the Y direction is calculated by "Ey=K2+K4·y+K6·x". In a case where the overlay deviation component is expressed by polynomial regression, not only K1 to K6 but also a coefficient assigned to a higher-order overlay component may be used as the polynomial regression coefficient. The overlay (alignment) measurement results can be broken down for each K value using polynomial regression. Alignment corresponds to the wafer shape in the exposure apparatus standard. The overlay deviation amount corresponds to displacement in pattern between the alignment destination and the alignment source of the wafer WF. Specifically, the component that cannot be corrected by exposure process based on the alignment measurement results serves as the overlay deviation amount. Hereinafter, the overlay deviation component of a magnification component generated in the wafer surface is also referred to as "wafer magnification" or "wafer magnification component".

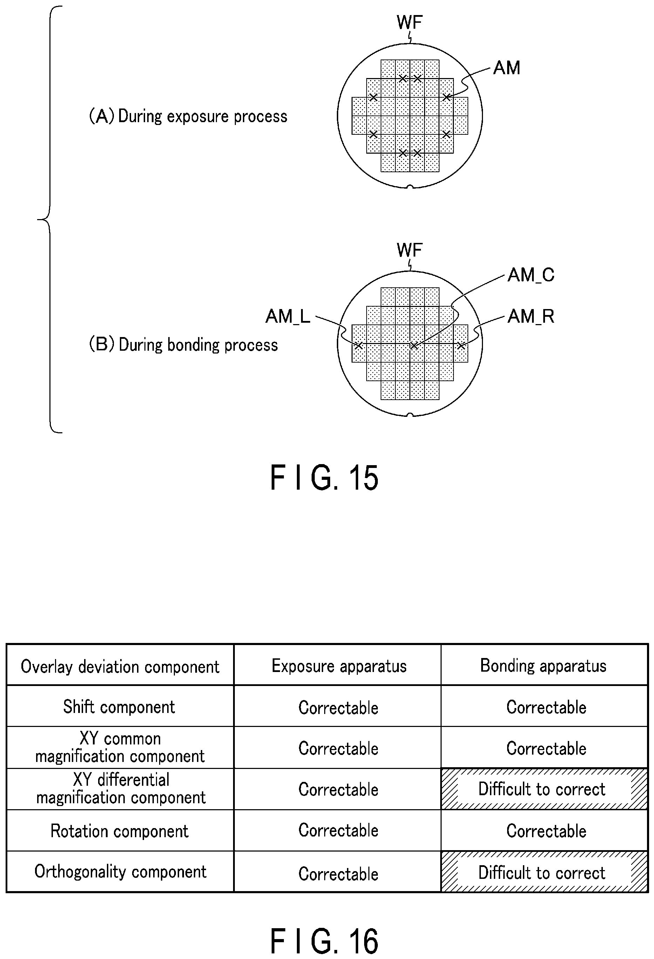

FIG. 15 is a schematic diagram illustrating examples of arrangement of alignment marks AM used in the semiconductor device manufacturing process according to the embodiment. (A) of FIG. 15 illustrates positions of alignment marks AM of the wafer WF, which are measured during the exposure process. (B) of FIG. 15 illustrates positions of alignment marks AM of the wafer WF, which are measured during the bonding process.

As illustrated in (A) of FIG. 15, the exposure apparatus 20 can, during the exposure process, measure the alignment marks AM at multiple points (at least three or more) arranged on the wafer WF. The exposure apparatus 20 can measure the alignment marks AM based on reference points set in the exposure apparatus 20. Further, the exposure apparatus 20 is capable of calculating correction values for the overlay deviation components, such as the shift components, the magnification components, and the orthogonality components in the X direction and the Y direction by performing, using an orthogonal coordinate system, function approximation of the measurement results for the alignment marks AM at multiple points. As a result, the exposure apparatus 20 is capable of correcting each of the overlay deviation components of shot units and the overlay deviation components in the wafer surface. Specifically, when the exposure apparatus 20 calculates the wafer magnification in the X direction and the wafer magnification in the Y direction by alignment in the exposure process, the exposure apparatus 20 uses measurement results for the three or more alignment marks AM arranged on the substrate.

As illustrated in (B) of FIG. 15, the bonding apparatus 30 measures, for example, three alignment marks AM_C, AM_L, and AM_R arranged on the wafer WF (upper wafer UW and lower wafer LW), during the bonding process. The alignment mark AM_C is disposed in the vicinity of the center of the wafer. The bonding apparatus aligns the shift component of the wafer based on the measurement result for the alignment mark AM_C of each of the upper wafer UW and the lower wafer LW. The alignment marks AM_L and AM_R are arranged on one side and on the other side of the outer periphery of the wafer, respectively. The bonding apparatus 30 aligns the rotation component based on the measurement results for the alignment marks AM_L and AM_R of the upper wafer UW and the lower wafer LW. In this manner, the bonding apparatus 30 is capable of calculating correction values for the shift component and the rotation component, and correcting simple overlay deviation components in the wafer plane. The bonding apparatus 30 is also capable of correcting the wafer magnification common to the X direction and the Y direction by deforming the stage holding the lower wafer LW.

FIG. 16 is a table illustrating an example of the correction performance for overlay deviation components in a wafer surface of the exposure apparatus 20 and the bonding apparatus 30 that are used in the semiconductor device manufacturing process according to the embodiment. As illustrated in FIG. 16, the shift component can be corrected in both the exposure apparatus 20 and the bonding apparatus 30. The wafer magnification (XY common magnification component) common to the X direction and the Y direction can be corrected in both the exposure apparatus 20 and the bonding apparatus 30. The wafer magnification (XY differential magnification component) having a difference between the X direction and the Y direction can be corrected in the exposure apparatus 20. On the other hand, it is difficult to correct the XY differential magnification component in the bonding apparatus 30. The rotation component (orthogonality component common to the X direction and the Y direction) can be corrected in both the exposure apparatus 20 and the bonding apparatus 30. The orthogonality component can be corrected in the exposure apparatus 20. On the other hand, it is difficult to correct the orthogonality component in the bonding apparatus 30.

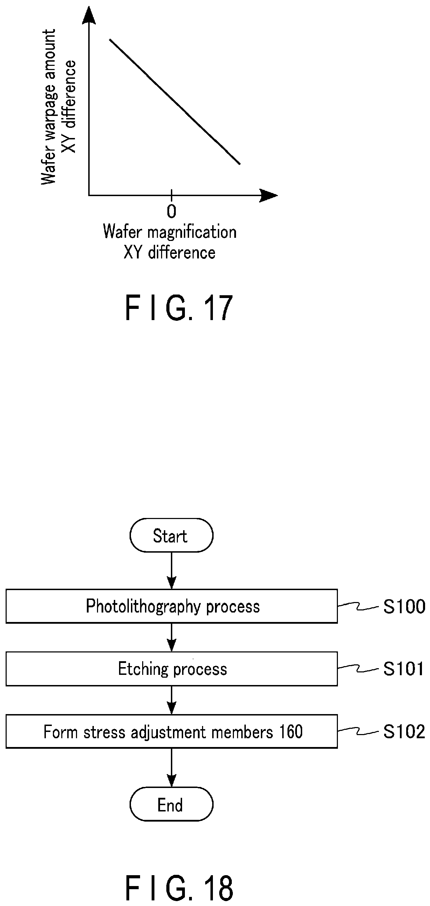

FIG. 17 is a graph illustrating an example of relationship between a wafer warpage amount XY difference and a wafer magnification XY difference. The wafer warpage amount XY difference corresponds to a difference between the warpage amount of the wafer WF in the X direction and the warpage amount of the wafer WF in the Y direction. Warpage of the wafer WF can occur due to stress (film stress) of a film formed on the wafer WF. The wafer magnification XY difference corresponds to a difference (MagX-MagY) between the wafer magnification (MagX) in the X direction and the wafer magnification (MagY) in the Y direction. In the following explanation, the difference between the wafer magnification in the X direction and the wafer magnification in the Y direction is also referred to as "D_MagXY").

As illustrated in FIG. 17, the wafer magnification XY difference tends to change according to the wafer warpage amount XY difference. For example, in a case where the wafer magnification XY difference is negative, the wafer magnification in the Y direction is larger than the wafer magnification in the X direction, and the wafer WF is deformed in a vertically long shape (elliptical shape in which the Y direction corresponds to the major axis and the X direction corresponds to the minor axis). In a case where the wafer magnification XY difference is zero, the wafer magnification in the X direction is equal to the wafer magnification in the Y direction, and the wafer WF has a shape close to a perfect circle. In a case where the wafer magnification XY difference is positive, the wafer magnification in the X direction is larger than the wafer magnification in the Y direction, and the wafer WF is deformed in a laterally long shape (elliptical shape in which the X direction corresponds to the major axis and the Y direction corresponds to the minor axis).

### <3-1> Method for forming film stress adjustment layer

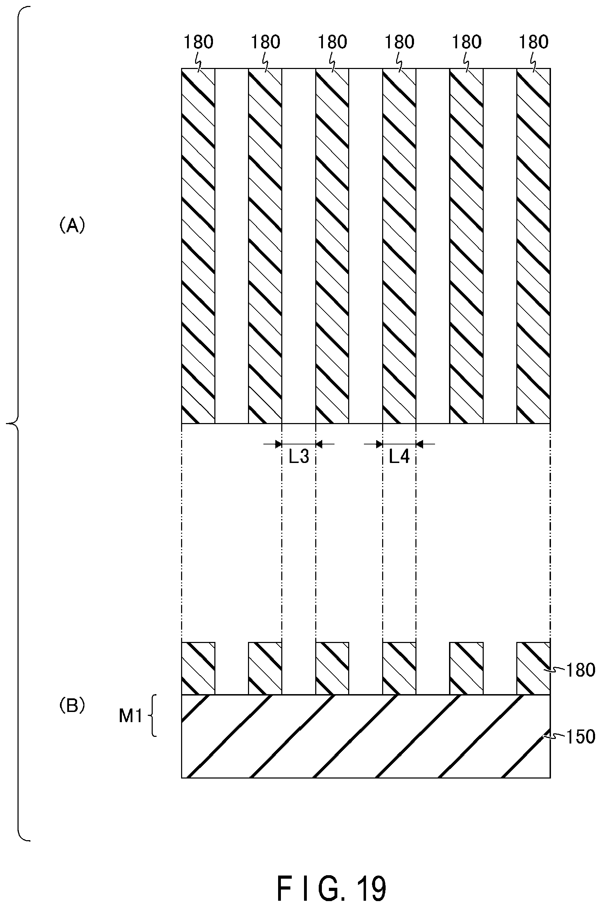

FIG. 18 is a flowchart illustrating an example of a process for forming a film stress adjustment layer AL included in the semiconductor device manufacturing process according to the embodiment. Each of FIG. 19 to FIG. 21 is a schematic diagram illustrating an example of a structure in formation of a film stress adjustment layer AL of the semiconductor device according to the embodiment. (A) of each of FIG. 19 to FIG. 21 illustrates part of a planar structure in a region in which the film stress adjustment layer AL is formed, in an extracted manner. (B) of each of FIG. 19 to FIG. 21 illustrates part of a cross-sectional structure in the region illustrated in (A), in an extracted manner. The following is an explanation of a process for forming the film stress adjustment layer AL, properly with reference to FIG. 18.

When the wafer WF is processed to a stage before the predetermined exposure process, a series of processes in FIG. 18 are started (Start). The present example illustrates the case where the film stress adjustment layer AL is formed in the interconnect layer M1. In addition, suppose that the insulating layer 150 is formed in the upper surface of the wafer WF carried to the stage before the predetermined exposure process. In the present example, the height at which the insulating layer 150 is formed includes the interconnect layer M1.

First, a photolithography process is executed (S100). Specifically, first, a resist material 180 is applied onto the insulating layer 150. In the present example, the resist material 180 is a positive-type resist. Thereafter, the exposure apparatus 20 transfers a predetermined mask pattern onto the resist material 180 by an exposure process described later. Thereafter, when a development process is executed, a line-and-space pattern of the resist material 180 is formed, as illustrated in FIG. 19. In the present example, in the line-and-space pattern of the resist material 180, a size (width) of each space portion is "L3", and a size (width) of each line portion is "L4".

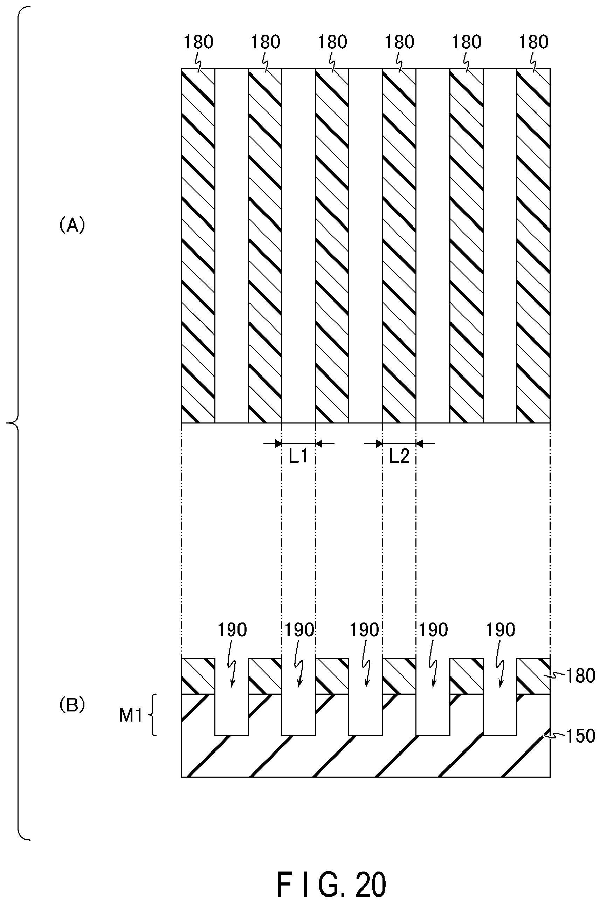

Thereafter, an etching process is executed (S101). The etching process in the process of S101 is an anisotropic etching process, such as reactive ion etching (RIE). In this manner, as illustrated in FIG. 20, a plurality of trench portions 190 are formed in an upper portion of the insulating layer 150, on the basis of the shape of the resist material 180. The width of each trench portion 190 corresponds to the size L1 illustrated in FIG. 8, and is based on the size L3 of each space portion of the resist material 180 and the processing property of the etching process. An interval between adjacent trench portions 190 corresponds to the size L2 illustrated in FIG. 8, and is based on the size L4 of each line portion of the resist material 180 and the processing property of the etching process. The process at S101 may be an isotropic etching process or an anisotropic etching process other than RIE, as long as a desired shape can be formed. After the process at S101, the resist material 180 is removed.

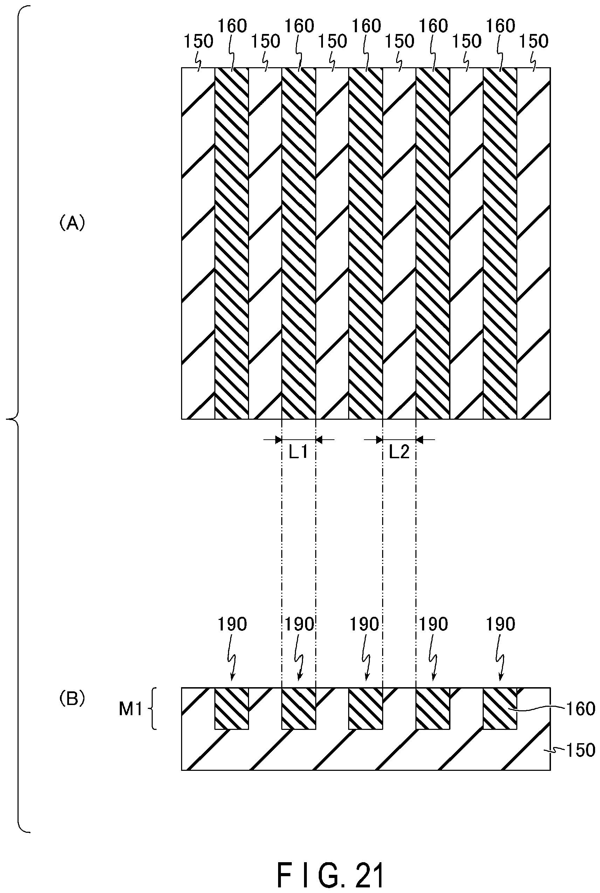

Thereafter, the stress adjustment members 160 are formed (S102). Specifically, the stress adjustment members 160 are formed by, for example, chemical vapor deposition (CVD). In this manner, the trench portions 190 are filled with the stress adjustment members 160. Thereafter, portions of the stress adjustment members 160 provided on the upper portion of the interconnect layer M1 are removed by, for example, chemical mechanical polishing (CMP). This process forms a structure in which the stress adjustment members 160 are left in the respective trench portions 190, as illustrated in FIG. 21. The method used for forming the stress adjustment members 160 can properly be changed according to the type of the stress adjustment members 160. The intensity of compressive stress and/or tensile stress of the stress adjustment members 160 can be changed according to the method for forming the stress adjustment members 160. The film stress adjustment layer AL is formed as described above, and a series of processes in FIG. 18 is finished (end).

### <3-2> Exposure method

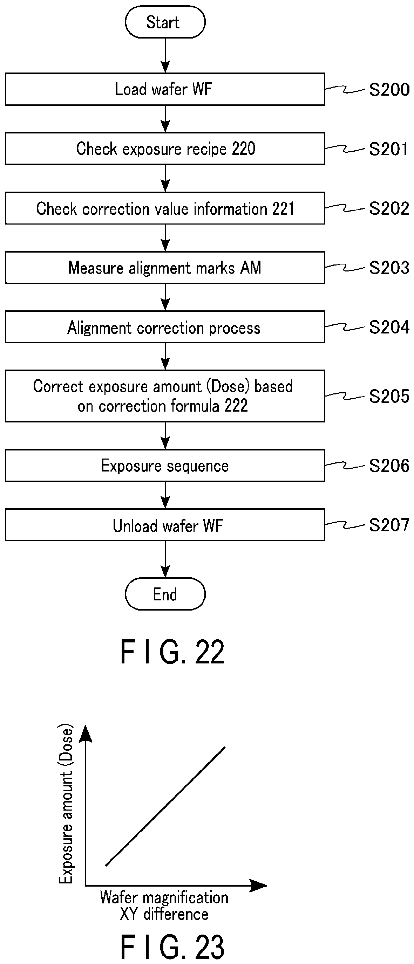

FIG. 22 is a flowchart illustrating an example of an exposure method of the exposure apparatus 20 according to the embodiment. The following is an explanation of an example of a specific process using the exposure apparatus 20 in the method for manufacturing a semiconductor device according to the embodiment, with reference to FIG. 22. The semiconductor device (for example, memory device 10) including the film stress adjustment layer AL is manufactured using the following exposure method.

When the completion of the pre-process for the wafer WF is reported by the coating-development device, the exposure apparatus 20 starts the exposure process (Start).

First, the exposure apparatus 20 loads a wafer (S200). The wafer loaded from the coating-development device is held by the wafer stage 250.

Next, the exposure apparatus 20 checks the exposure recipe 220 (S201). As a result, the control device 21 determines process conditions to be applied to the loaded wafer WF.

Next, the exposure apparatus 20 checks the correction value information 221 (S202). In this manner, the control device 21 determines correction values for the exposure amount and/or the alignment to be applied to the loaded wafer WF. The correction values are based on correction values received from the server 40, for example.

Next, the exposure apparatus 20 measures the alignment marks AM (S203). More specifically, the camera 254 photographs a plurality of alignment marks AM arranged in predetermined positions on the wafer WF.

Next, the exposure apparatus 20 executes an alignment correction process (S204). More specifically, the control device 21 calculates alignment correction values for shot arrangements and shot shapes with which the wafer is to be exposed, based on the measurement results of the alignment marks AM. Alignment correction values include the difference between the wafer magnification component in the X direction and the wafer magnification component in the Y direction (D_MagXY). In other words, the controller 21 calculates the wafer magnification component in the X direction and the wafer magnification component in the Y direction based on the measurement results of a plurality of alignment marks AM. Furthermore, the exposure apparatus 20 applies the calculated alignment correction values to the alignment process parameters. In a case where the exposure apparatus 20 successively executes exposure processes for a plurality of wafers WF included in a lot, the exposure apparatus 20 may apply alignment correction values that are different between the wafers WF.

Next, the exposure apparatus 20 corrects the exposure amount (dose) based on the correction formula 222 (S205). Specifically, the control device 21 calculates the correction value of the exposure amount by substituting the difference (D_MagXY) between the wafer magnification component in the X direction and the wafer magnification component in the Y direction, in the alignment correction values calculated by the process at S204, for the value in the correction formula 222. Thereafter, the control device 21 reflects the calculated correction value of the exposure amount on the setting of the exposure amount provided by the exposure recipe 220. The process at S205 may be omitted in a case where the process is not a process associated with formation of the film stress adjustment layer AL.

Next, the exposure apparatus 20 executes an exposure sequence (S206). More specifically, the control device 21 controls the light source 252, the wafer stage 250, and the reticle stage 251 based on the alignment process parameters determined in the process at S204 and the setting of the exposure amount determined in the process at S205, and irradiates the wafer WF with the light transmitted through the mask by using a step-and-repeat method.

When the wafer is unloaded, the exposure apparatus 20 ends the exposure process (End).

In the process at S205 explained above, the exposure amount is adjusted such that the wafer magnification XY difference is reduced. The structure is not limited thereto, but a target (reference) value of the wafer magnification XY difference may be set in the process at S205. As the reference value of the wafer magnification XY difference, for example, a value of the wafer magnification XY difference of the wafers WF combined in the bonding process is used. In this case, the exposure amount is adjusted in the process at S205 such that the wafer magnification XY difference of one wafer WF of the combined wafers WF becomes closer to the value of the wafer magnification XY difference of the other wafer WF.

### <3-3> Details of correction formula 222

FIG. 23 is a graph illustrating an example of the correction formula 222 used in the exposure apparatus 20 according to the embodiment. In the graph illustrated in FIG. 23, the horizontal axis indicates the wafer magnification XY difference, and the vertical axis indicates the exposure amount (dose). As illustrated in FIG. 23, the correction formula 222 is a numerical formula indicating relationship between the wafer magnification XY difference and the exposure amount. The correction formula 222 is, for example, a function expressed by a linear function and a function with which the exposure amount increases as the wafer magnification XY difference increases. The correction formula 222 may be changed according to the arrangement of the film stress adjustment layer AL, the thickness of the stress adjustment member 160, the width (arrangement density) of the stress adjustment member 160, the definition of the wafer magnification XY difference, and/or the type of the resist material used for the exposure process, and the like. A difference from the standard of the wafer magnification of the exposure apparatus 20 may be considered, as the definition of the wafer magnification XY difference. In this case, even with the same wafer WF, a difference may occur in the wafer magnification XY difference for each exposure apparatus 20.

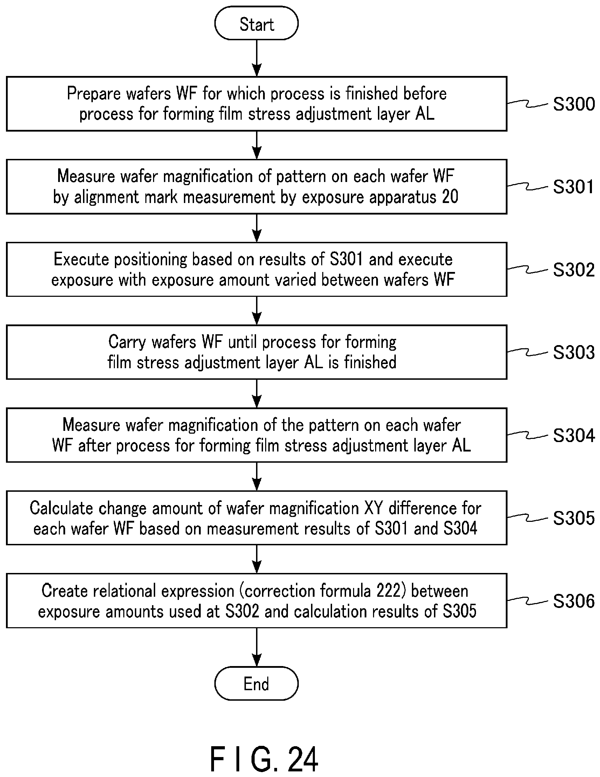

FIG. 24 is a flowchart illustrating an example of a method for creating the correction formula 222 used in the exposure apparatus 20 according to the embodiment. The following is an explanation of an example of the method for creating the correction formula 222 with reference to FIG. 24.

First, a plurality of wafers WF for which the process is finished before the process for forming the film stress adjustment layer AL are prepared (S300).

Next, in the exposure process, the wafer magnification of the pattern on each wafer WF is measured by alignment mark measurement by the exposure apparatus 20 (S301). The measurement results of the wafer magnifications in the process at S301 may be stored in the server 40 as well as the exposure apparatus 20.

Next, the exposure apparatus 20 executes positioning (alignment) based on the results of S301, and executes exposure with the exposure amount varied (changed) between the wafers WF (S302). The range of the exposure amount set at S302 is set such that, in a case where a pattern is to be formed simultaneously with the film stress adjustment layer AL, the size of the pattern falls within the specification of the processed rule.

Thereafter, the wafers WF are carried until the process for forming the film stress adjustment layer AL is finished (S303).

Thereafter, after the process for forming the film stress adjustment layer AL, the wafer magnification of the pattern on each wafer WF is measured (S304). The pattern measured in the process at S304 may be the same as the pattern measured in the process at S301, or the pattern formed in the process at S302. The displacement between the pattern measured in the process at S301 and the pattern formed in the process at S302 has been reduced to substantially zero. For this reason, substantially the same measurement value is acquired in either of the case of executing alignment measurement of the pattern of S301 and the case of executing alignment measurement of the pattern of S302. The measurement results of the wafer magnifications in the process at S304 are stored in the exposure apparatus 20 or the server 40. Measurement of the wafer magnifications in the process at S304 may be executed by the exposure apparatus 20 or the overlay measurement device.

Thereafter, a change amount of the wafer magnification XY difference is calculated for each wafer WF on the basis of the measurement results of S301 and S304 (S305). The calculated wafer magnification XY differences for the respective wafers WF are stored in the exposure apparatus 20 or the server 40.

Thereafter, a relational expression (correction formula 222) between the exposure amounts used at S302 and the calculation results of S305 is calculated (S306). The process at S305 may be executed by the exposure apparatus 20 or the server 40.

As described above, the correction formula 222 is generated (End). The generated correction formula 222 is stored in the exposure apparatus 20. The correction formula 222 may be stored in the server 40. The correction formula 222 may be shared between a plurality of exposure apparatuses 20.

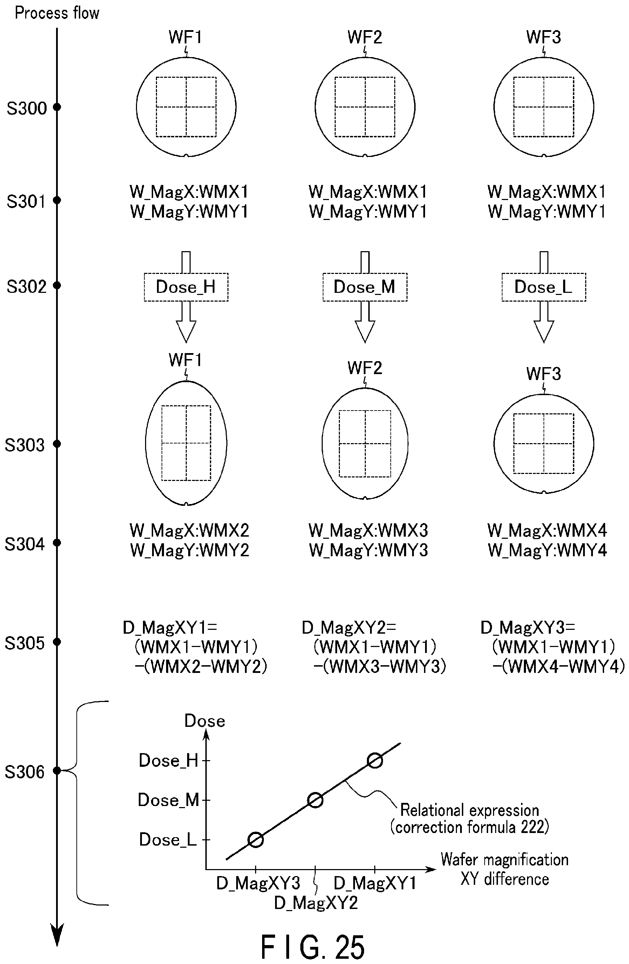

FIG. 25 is a schematic diagram illustrating a specific example of the method for creating the correction formula 222 used in the exposure apparatus 20 according to the embodiment. The following is an explanation of the method for creating the correction formula 222 in a case of using three wafers WF1 to WF3 with reference to FIG. 25. The shapes of the wafers WF and the shots illustrated in the drawings referred to hereinafter are expressed in an exaggerated manner.

First, three wafers WF1 to WF3 are prepared by the process at S300.

Thereafter, by the process at S301, the wafer magnification of each of the wafers WF1 to WF3 is measured before formation of the film stress adjustment layer AL. In the present example, in each of the wafers WF1 to WF3, the wafer magnification W_MagX in the X direction is WMX1, and the wafer magnification W_MagY in the Y direction is WMY1.

Thereafter, the exposure process with the varied exposure amount is executed by the process at S302. In the present example, the exposure amount applied to the wafer WF1 is Dose_H, the exposure amount applied to the wafer WF2 is Dose_M, and the exposure amount applied to the wafer WF3 is Dose_L. The magnitude relation of the exposure amounts is "Dose_H>Dose_M>Dose_L".

Thereafter, a film stress adjustment layer AL is formed in each of the wafers WF1 to WF3 by the process at S303. In a case where the exposure amount is varied in formation of the film stress adjustment layer AL illustrated in FIG. 9, the shape of the wafer WF changes according to the magnitude of the exposure amount. For example, the change amount of the wafer magnification XY difference increases as the exposure amount increases.

Thereafter, by the process at S304, the wafer magnification of each of the wafers WF1 to WF3 is measured after formation of the film stress adjustment layer AL. In the present example, in the wafer WF1, W_MagX is WMX2, and W_MagY is WMY2. In the wafer WF2, W_MagX is WMX3, and W_MagY is WMY3. In the wafer WF3, W_MagX is WMX4, and W_MagY is WMY4 .

Thereafter, the wafer magnification XY difference is calculated by the process at S305. For example, the wafer magnification XY difference in the wafer WF1 is calculated by "D_MagXY1= (WMX1-WMY1) - (WMX2-WMY2)". The wafer magnification XY difference in the wafer WF2 is calculated by "D_MagXY2= (WMX1-WMY1) - (WMX3-WMY3)". The wafer magnification XY difference in the wafer WF3 is calculated by "D_MagXY3= (WMX1-WMY1) - (WMX4-WMY4)".

Thereafter, the correction formula 222 is created by the process at S306. Specifically, the relationship between Dose_H and D_MagXY1 is plotted from the process results of the wafer WF1, the relationship between Dose_M and D_MagXY2 is plotted from the process results of the wafer WF2, and the relationship between Dose_L and D_MagXY3 is plotted from the process results of the wafer WF3. Thereafter, for example, the correction formula 222 is calculated by executing regression analysis using the plotted points. The accuracy of the correction formula 222 increases as the number of wafers WF used as samples increases.

### <3-4> Specific example of method for correcting wafer magnification using film stress adjustment layer AL

The following is an explanation of a specific example of the method for correcting the wafer magnification using the film stress adjustment layer AL.

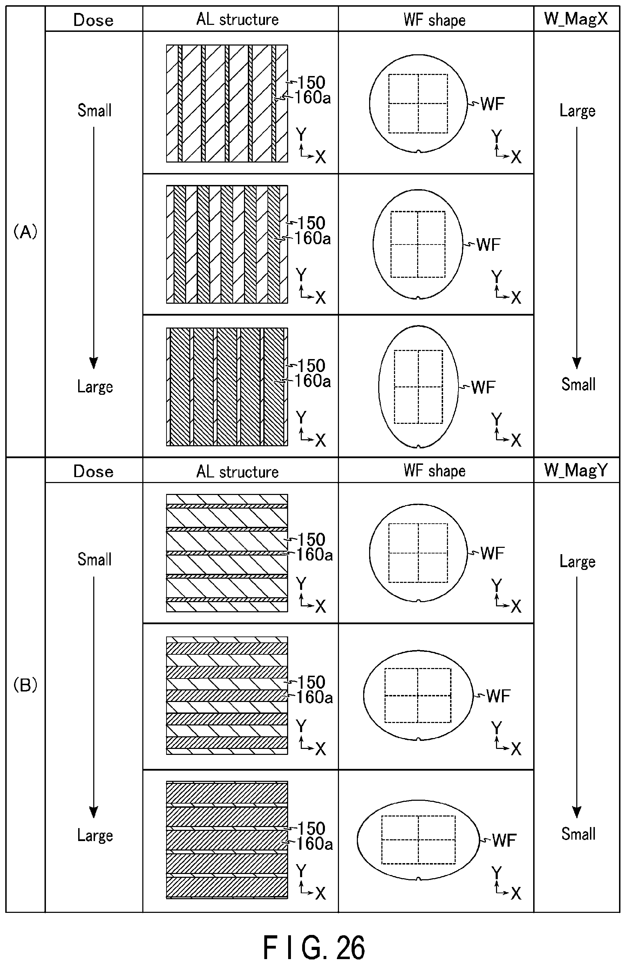

FIG. 26 is a schematic diagram illustrating an example of change of the wafer magnification in a case where a shrinkable film is used in the film stress adjustment layer AL of the semiconductor device according to the embodiment. (A) of FIG. 26 corresponds to the case where the extending direction of the stress adjustment members 160a is the Y direction. (B) of FIG. 26 corresponds to the case where the extending direction of the stress adjustment members 160a is the X direction. As illustrated in FIG. 26, the width of each of the stress adjustment members 160 increases as the exposure amount increases.

In the example illustrated in (A) of FIG. 26, the ratio of the shrinkable films arranged in the X direction in the film stress adjustment layer AL increases as the exposure amount increases. In this case, as the ratio of the shrinkable films arranged in the X direction increases, the compressive stress in the X direction for the wafer WF tends to increase, and the wafer magnification W_MagX in the X direction tends to decrease. For this reason, in the present example, the wafer magnification XY difference changes in the negative direction as the exposure amount increases.

On the other hand, in the example in (B) of FIG. 26, the ratio of the shrinkable films arranged in the Y direction in the film stress adjustment layer AL increases as the exposure amount increases. In this case, as the ratio of the shrinkable films arranged in the Y direction increases, the compressive stress in the Y direction for the wafer WF tends to increase, and the wafer magnification W_MagY in the Y direction tends to decrease. For this reason, in the present example, the wafer magnification XY difference changes in the positive direction as the exposure amount increases.

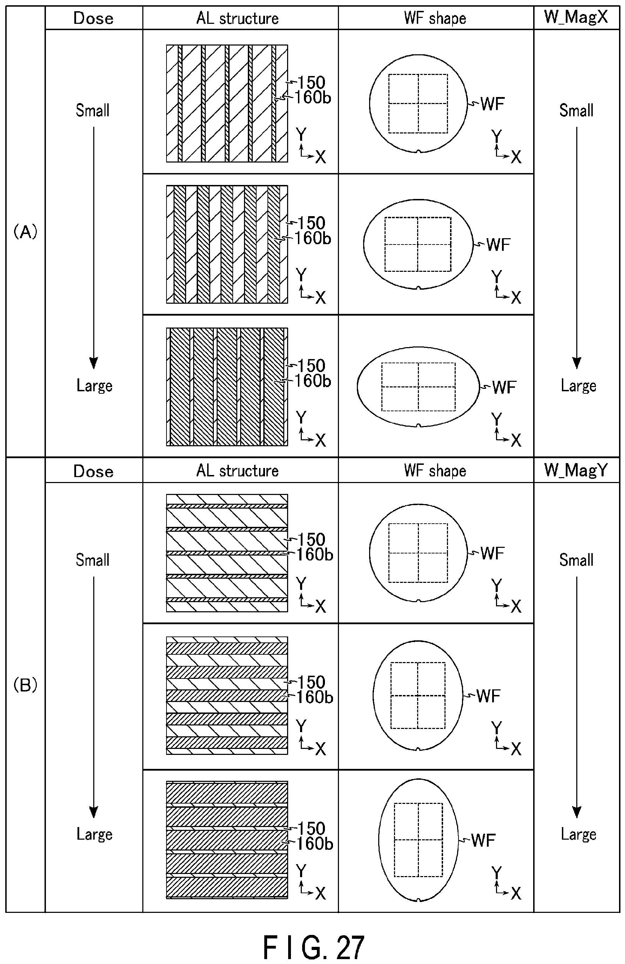

FIG. 27 is a schematic diagram illustrating an example of change of the wafer magnification in a case where an expandable film is used in the film stress adjustment layer AL of the semiconductor device according to the embodiment. (A) of FIG. 27 corresponds to the case where the extending direction of the stress adjustment members 160b is the Y direction. (B) of FIG. 27 corresponds to the case where the extending direction of the stress adjustment members 160b is the X direction. As illustrated in FIG. 27, the width of each of the stress adjustment members 160b increases as the exposure amount increases.

In the example illustrated in (A) of FIG. 27, the ratio of the expandable films arranged in the X direction in the film stress adjustment layer AL increases as the exposure amount increases. In this case, as the ratio of the expandable films arranged in the X direction increases, the tensile stress in the X direction for the wafer WF tends to increase, and the wafer magnification W_MagX in the X direction tends to increase. For this reason, in the present example, the wafer magnification XY difference changes in the positive direction as the exposure amount increases.

On the other hand, in the example in (B) of FIG. 27, the ratio of the expandable films arranged in the Y direction in the film stress adjustment layer AL increases as the exposure amount increases. In this case, as the ratio of the expandable films arranged in the Y direction increases, the tensile stress in the Y direction for the wafer WF tends to increase, and the wafer magnification W_MagY in the Y direction tends to increase. For this reason, in the present example, the wafer magnification XY difference changes in the negative direction as the exposure amount increases.

The explanation above illustrates the case where the resist material 180 is the positive type material, but the structure is not limited thereto. In the exposure process in formation of the film stress adjustment layer AL, a negative type resist material may be used. In this case, the width of the stress adjustment members 160 decreases the exposure amount increases. For this reason, in a case where the negative type resist material is used and the stress adjustment members 160a (shrinkable film) are used, the ratio of the shrinkable films arranged in the X direction or the Y direction increases as the exposure amount decreases, and the wafer magnification in the X direction or the Y direction increases. In a case where the negative type resist material is used and the stress adjustment members 160b (expandable film) are used, the ratio of the shrinkable films arranged in the X direction or the Y direction increases as the exposure amount decreases, and the wafer magnification in the X direction or the Y direction increases. The exposure apparatus 20 may use a plurality of correction formulae 222 according to the type and/or number of film stress adjustment layers AL included in the semiconductor device.

### <4> Advantageous effects of embodiment

With the exposure apparatus 20, the exposure method, and the method for manufacturing a semiconductor device described above, it is possible to improve semiconductor device yield. Hereinafter, the details of the advantageous effect will be described.

In a semiconductor device formed by bonding two wafers, the states of wafer magnification (that is, the sizes of the wafers) before one wafer is bonded to the other wafer may be different. For example, the wafer magnification may vary depending on the respective film stresses (that is, the warpage of the wafer) on the front and back surfaces of the wafer. For this reason, the variation in the wafer magnification may be different between one wafer and the other wafer, depending on the design of the circuit, the elements, and the like. In addition, the wafer magnification XY difference may differ according to the difference between apparatuses of the exposure apparatus 20 used for the first exposure process for the wafer.

As described with reference to FIG. 17, the bonding apparatus 30 is capable of correcting the wafer magnification common to the X direction and the Y direction in the bonding process. On the other hand, the bonding apparatus 30 has difficulty in correcting the wafer magnification XY difference. Accordingly, to improve the overlay accuracy in the bonding process, it is preferable to adjust the wafer magnification XY difference in one wafer to the wafer magnification XY difference in the other wafer.

For this reason, the memory device 10 according to the embodiment includes the film stress adjustment layer AL that can be used for adjustment of the warpage of the wafer. In addition, the exposure apparatus 20 according to the embodiment controls the dimension of the line-and space pattern in the predetermined process used for formation of the film stress adjustment layer AL by adjusting the exposure amount based on the alignment results.

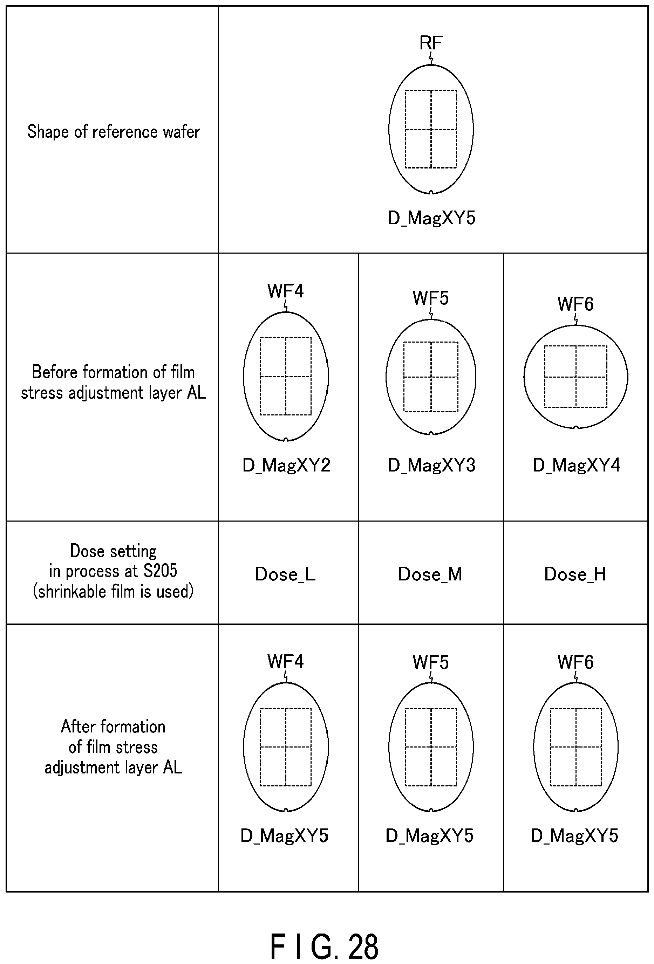

FIG. 28 is a schematic diagram illustrating an example of adjustment of the wafer magnification in the method for manufacturing a semiconductor device according to the embodiment. The example illustrated in FIG. 28 illustrates the case of forming the film stress adjustment layer AL using the exposure method described above for wafers WF4, WF5, and WF6 associated with a reference wafer RF. The wafer magnification XY difference of the reference wafer RF is D_MagXY5. In the reference wafer RF, the wafer magnification in the X direction is smaller than the wafer magnification in the Y direction. Wafer magnification XY differences of the wafers WF4, WF5, and WF6 are D_MagXY2, D_MagXY3, and D_MagXY4, respectively. The magnitude relation of the wafer magnification XY differences is "D_MagXY5≈D_MagXY2>D_MagXY3>D_MagXY4". In this case, the exposure amounts in the process at S205 are set to Dose_L, Dose_M, and Dose_H for the wafers WF4, WF5, and WF6, respectively, in a case where shrinkable films are used as the stress adjustment members 160. For this reason, the change amounts of the wafer magnification XY differences satisfies "WF4<WF5<WF6". In this manner, the shapes of the wafers WF4, WF5, and WF6 after formation of the film stress adjustment layer AL are adjusted to have D_MagXY5 in the same manner as the reference wafer RF.

As described above, the method for manufacturing a semiconductor device according to the embodiment enables suppression of the overlay deviation in the bonding process, because the wafer magnification XY differences of the two wafers WF to be bonded can be set substantially equal to each other. Accordingly, the exposure apparatus 20, the exposure method, and the method for manufacturing a semiconductor device according to the embodiment is capable of improving semiconductor device yield.

In a case where the semiconductor device includes both the film stress adjustment layer AL including a plurality of stress adjustment members 160, which have respective portions extending in the Y direction and arranged at regular intervals along the X direction, and the film stress adjustment layer AL including a plurality of stress adjustment members 160, which have respective portions extending in the X direction and arranged at regular intervals along the Y direction, it is preferable that the film stress adjustment layers AL are provided at mutually different heights. This structure enables suppression of the warpage of the wafer WF in a desired direction, regardless of the positive and negative of the wafer magnification XY difference.

In addition, in a case where the memory device 10 is used as the semiconductor device, the memory device 10 includes the memory chip MC including a structure in which memory cells are stacked in a three-dimensional manner, and the CMOS chip CC including other control circuits and the like. In the memory chip MC and the CMOS chip CC, the variation in wafer magnification tends to be larger between the wafers in the memory chip MC. More specifically, because the memory chip MC includes the memory cell array 13 formed in a high layer, the variation in the amount of warpage of the wafer increases, and the variation in wafer magnification may increase. On the other hand, the arrangement of the shots of the CMOS chip CC is close to an ideal lattice that is based on the exposure apparatus. Therefore, when the bonding process is executed, the wafer whereon the memory chip MC is formed is preferably allocated to the lower wafer LW for which the wafer magnification can be corrected, and the wafer whereon the CMOS chip CC is formed is preferably allocated to the upper wafer UW. In addition, the film stress adjustment layer AL is preferably disposed properly according to the state of the warpage of the wafer occurring during manufacturing. This structure enables improvement of the yield of the memory device 10.

### <5> Further embodiment

In the embodiment described above, the flowcharts used for explanation of the operations are mere examples. In the operations described using the flowcharts, the order of processes are interchangeable within a permissible range, other processes may be added, or some of the processes may be omitted. In the present specification, a micro processing unit (MPU), an application specific integrated circuit (ASIC), a field-programmable gate array (FPGA), or the like, may also be used instead of the CPU. Furthermore, each of the processes described in the embodiment may be realized using dedicated hardware. The processes described in the embodiment may be a mixture of processes executed by software and processes executed by hardware, or only either one of such processes may be used.

In the present specification, the term "connection" indicates that two elements are electrically connected, and does not preclude another element being interposed therebetween. The term "electrically connected" may signify that an insulator is interposed, as long as operation like that afforded by an electrical connection is possible. The term "plan view" corresponds to, for example, viewing an object in a direction perpendicular to the surface of the semiconductor substrate 140. The term "region" may be regarded as indicating a configuration that is included in the semiconductor substrate 140 of the CMOS chip CC. For example, in a case where it is prescribed that the semiconductor substrate 140 includes the memory region MR, the memory region MR is associated with an upper region of the semiconductor substrate 140. The bonding pads BP may also be referred to as "joint metal". The camera 254 of the exposure apparatus 20 may also be configured by being divided into an optical system (microscope) and a light receiving sensor. In the present specification, "overlap deviation" may also be paraphrased as "misalignment".

In the present specification, the amount of warpage of a wafer is expressed, for example, by a difference between the heights of the wafer at its peripheral portion and at its central portion. A micrometer (µm) may be used as a unit of the amount of warpage of the wafer. The amount of warpage of the wafer may be expressed by a signed distance from a three-point reference plane, based on the measurement results of the height of the wafer at the center. The amount of warpage of the wafer may be set, for example, to a positive value if it is above the three-point reference plane and to a negative value if it is below the plane. The amount of warpage of the wafer may be measured through the calculation of the shape (warpage) of the wafer by measuring the heights at different coordinates of the wafer using, for example, a laser displacement gauge, a confocal displacement gauge, a capacitance formula, a heterodyne interferometer, and a Fizeau interferometer.

The configuration of the memory device 10 explained in the embodiment is a mere example, and the configuration of the memory device 10 is not limited thereto. The circuit configuration, planar layout, and cross-sectional structure of the memory device 10 can appropriately be changed according to the design of the memory device 10. For example, although a case where the memory chip MC is provided on the CMOS chip CC has been given by way of an example in the embodiment, the CMOS chip CC may also be provided on the memory chip MC. Although a case where the memory chip MC is allocated to the lower wafer LW and the CMOS chip CC is allocated to the upper wafer UW has been given by way of an example, the memory chip MC may be allocated to the upper wafer UW, and the CMOS chip CC may be allocated to the lower wafer LW. In a case where the manufacturing method described in the embodiment is applied, a wafer exhibiting a large variation in wafer magnification between wafers is preferably allocated to the lower wafer LW. Thus, because overlay deviation in the bonding process can be suppressed, the occurrence of defects caused by such overlay deviation can be suppressed.

Some or all of the embodiments described above can be described as in the following supplementary notes, but is not limited thereto:

### [Supplementary Note 1]

An exposure apparatus (20) exposing a substrate (WF) to light, the exposure apparatus comprising:
a light source (252),
a stage (250) configured to hold the substrate to be exposed,
a control device (21) configured to correct an exposure amount of light, wherein
the control device is configured to:
   calculate magnification components in a first direction (X) and a second direction (Y), based on measurement results of three or more alignment marks, the first direction and the second direction crossing each other and parallel with a surface of the substrate; and
   correct the exposure amount based on a value of a difference between the magnification component of the first direction and the magnification component of the second direction.

### [Supplementary Note 2]

The exposure apparatus of Supplementary Note 1, wherein
the control device (21) is configured to:
correct the exposure amount to a first exposure amount in a case where the difference between the magnification component of the first direction and the magnification component of the second direction is a first value; and
correct the exposure amount to a second exposure amount smaller than the first exposure amount in a case where the difference between the magnification component of the first direction and the magnification component of the second direction is a second value larger than the first value.

### [Supplementary Note 3]

The exposure apparatus of Supplementary Note 1, wherein
the control device (21) is configured to:
correct the exposure amount to a first exposure amount in a case where the difference between the magnification component of the first direction and the magnification component of the second direction is a first value; and
correct the exposure amount to a third exposure amount larger than the first exposure amount in a case where the difference between the magnification component of the first direction and the magnification component of the second direction is a second value larger than the first value.

### [Supplementary Note 4]

The exposure apparatus of Supplementary Note 1, wherein
the control device (21) is configured to change a width of a pattern formed in the substrate by adjusting the exposure amount.

### [Supplementary Note 5]

The exposure apparatus of Supplementary Note 1, wherein
the control device (21) is configured to correct the exposure amount based on the difference between the magnification component of the first direction and the magnification component of the second direction, and based on a reference value.

### [Supplementary Note 6]

The exposure apparatus of Supplementary Note 1, wherein
the control device (21) is configured to create a relational expression between the measurement results of the alignment marks and correction values of respective exposure amounts of a plurality of the substrates.

### [Supplementary Note 7]

An exposure method for exposing a substrate to light, the exposure method comprising:
correcting an exposure amount of light; and
exposing the substrate with corrected exposure amount of light, wherein
the correcting of the exposure amount is based on a value of a difference between a magnification component of a first direction (X) and a magnification component of a second direction (Y), the first direction and the second direction crossing each other and parallel with a surface of the substrate.

### [Supplementary Note 8]

The exposure method of Supplementary Note 7, further comprising:
in the correcting of the exposure amount,
correcting the exposure amount to a first exposure amount in a case where the difference between the magnification component of the first direction and the magnification component of the second direction is a first value, and
correcting the exposure amount to a second exposure amount smaller than the first exposure amount in a case where the difference between the magnification component of the first direction and the magnification component of the second direction is a second value larger than the first value.

### [Supplementary Note 9]

The exposure method of Supplementary Note 7, further comprising:
in the correcting of the exposure amount,
correcting the exposure amount to a first exposure amount in a case where the difference between the magnification component of the first direction and the magnification component of the second direction is a first value, and
correcting the exposure amount to a third exposure amount larger than the first exposure amount in a case where the difference between the magnification component of the first direction and the magnification component of the second direction is a second value larger than the first value.

### [Supplementary Note 10]

The exposure method of Supplementary Note 7, further comprising:
in the correcting of the exposure amount, correcting the exposure amount based on the difference between the magnification component of the first direction and the magnification component of the second direction, and based on a difference from a reference value.

### [Supplementary Note 11]

The exposure method of Supplementary Note 7, further comprising:
calculating a correction value of the exposure amount based on a relational expression between the measurement results of the alignment marks and the correction value of the exposure amount, wherein
the relational expression is created based on respective exposure amounts and alignment results of a plurality of the substrates.

### [Supplementary Note 12]

A method for manufacturing a semiconductor device including a substrate, the method comprising:
exposing the substrate to light with an exposure amount corrected based on measurement results of three or more alignment marks arranged on the substrate, wherein
the correcting of the exposure amount is based on a value of a difference between a magnification component of a first direction (X) and a magnification component of a second direction (Y), the first direction and the second direction crossing each other and parallel with a surface of the substrate.

### [Supplementary Note 13]

The method of Supplementary Note 12, further comprising:
in the correcting of the exposure amount,
correcting the exposure amount to a first exposure amount in a case where the difference between the magnification component of the first direction and the magnification component of the second direction is a first value; and
correcting the exposure amount to a second exposure amount smaller than the first exposure amount in a case where the difference between the magnification component of the first direction and the magnification component of the second direction is a second value larger than the first value.

### [Supplementary Note 14]

The method of Supplementary Note 12, further comprising:
in the correcting of the exposure amount,
correcting the exposure amount to a first exposure amount in a case where the difference between the magnification component of the first direction and the magnification component of the second direction is a first value; and
correcting the exposure amount to a third exposure amount larger than the first exposure amount in a case where the difference between the magnification component of the first direction and the magnification component of the second direction is a second value larger than the first value.

### [Supplementary Note 15]

The method of Supplementary Note 12, wherein
a width of a pattern formed in the substrate is changed by adjusting the exposure amount.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. Features of different embodiments may be combined in any appropriate combination in further embodiments. Apparatus features may be provided as method features and *vice versa.*

## Claims

1. An exposure apparatus (20) exposing a substrate (WF) to light, the exposure apparatus comprising:
a light source (252),
a stage (250) configured to hold the substrate to be exposed,
a control device (21) configured to correct an exposure amount of light, wherein
the control device is configured to:
calculate magnification components in a first direction (X) and a second direction (Y), based on measurement results of three or more alignment marks, the first direction and the second direction crossing each other and parallel with a surface of the substrate; and
correct the exposure amount based on a value of a difference between the magnification component of the first direction and the magnification component of the second direction.

2. The exposure apparatus of claim 1, wherein
the control device (21) is configured to:
correct the exposure amount to a first exposure amount in a case where the difference between the magnification component of the first direction and the magnification component of the second direction is a first value; and
correct the exposure amount to a second exposure amount smaller than the first exposure amount in a case where the difference between the magnification component of the first direction and the magnification component of the second direction is a second value larger than the first value.

3. The exposure apparatus of claim 1, wherein
the control device (21) is configured to:
correct the exposure amount to a first exposure amount in a case where the difference between the magnification component of the first direction and the magnification component of the second direction is a first value; and
correct the exposure amount to a third exposure amount larger than the first exposure amount in a case where the difference between the magnification component of the first direction and the magnification component of the second direction is a second value larger than the first value.

4. The exposure apparatus of any preceding claim, wherein
the control device (21) is configured to change a width of a pattern formed in the substrate by adjusting the exposure amount.

5. The exposure apparatus of any preceding claim, wherein
the control device (21) is configured to correct the exposure amount based on the difference between the magnification component of the first direction and the magnification component of the second direction, and based on a reference value.

6. The exposure apparatus of any preceding claim, wherein
the control device (21) is configured to create a relational expression between the measurement results of the alignment marks and correction values of respective exposure amounts of a plurality of the substrates.

7. An exposure method for exposing a substrate to light, the exposure method comprising:
correcting an exposure amount of light; and
exposing the substrate with corrected exposure amount of light, wherein
the correcting of the exposure amount is based on a value of a difference between a magnification component of a first direction (X) and a magnification component of a second direction (Y), the first direction and the second direction crossing each other and parallel with a surface of the substrate.

8. The exposure method of claim 7, further comprising:
in the correcting of the exposure amount,
correcting the exposure amount to a first exposure amount in a case where the difference between the magnification component of the first direction and the magnification component of the second direction is a first value, and
correcting the exposure amount to a second exposure amount smaller than the first exposure amount in a case where the difference between the magnification component of the first direction and the magnification component of the second direction is a second value larger than the first value.

9. The exposure method of claim 7, further comprising:
in the correcting of the exposure amount,
correcting the exposure amount to a first exposure amount in a case where the difference between the magnification component of the first direction and the magnification component of the second direction is a first value, and
correcting the exposure amount to a third exposure amount larger than the first exposure amount in a case where the difference between the magnification component of the first direction and the magnification component of the second direction is a second value larger than the first value.

10. The exposure method of any of claims 7 to 9, further comprising:
in the correcting of the exposure amount, correcting the exposure amount based on the difference between the magnification component of the first direction and the magnification component of the second direction, and based on a difference from a reference value.

11. The exposure method of any of claims 7 to 10, further comprising:
calculating a correction value of the exposure amount based on a relational expression between the measurement results of the alignment marks and the correction value of the exposure amount, wherein
the relational expression is created based on respective exposure amounts and alignment results of a plurality of the substrates.

12. A method of claim 7, wherein the method is a method for manufacturing a semiconductor device, and the semiconductor device includes including a substrate

13. The method of claim 12, wherein
a width of a pattern formed in the substrate is changed by adjusting the exposure amount.
